(19) Europäisches Patentamt

European Patent Office

Office européen des brevets

(11) **EP 2 947 836 A1**

(12) **EUROPEAN PATENT APPLICATION**

(43) Date of publication:
**25.11.2015  Bulletin 2015/48**

(21) Application number: **14169535.3**

(22) Date of filing: **22.05.2014**

(51) Int Cl.:
*H04L 27/34* (2006.01)          *H03M 13/11* (2006.01)
*H03M 13/25* (2006.01)          *H04L 1/00* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Panasonic Corporation**
**Kadoma-shi**
**Osaka 571-8501 (JP)**

(72) Inventors:
• **Klenner, Peter**
**63225 Langen (DE)**

• **Herrmann, Frank**
**63225 Langen (DE)**
• **Kimura, Tomohiro**
**Osaka-shi, Osaka 540-6207 (JP)**

(74) Representative: **Grünecker Patent- und**
**Rechtsanwälte**
**PartG mbB**
**Leopoldstraße 4**
**80802 München (DE)**

(54) **Cyclic-block permutations for 1D-4096-QAM with quasi-cyclic LDPC codes and code rates 6/15, 7/15, and 8/15**

(57)    The present invention relates to digital communication systems based on quasi-cyclic low-density parity-check (QC-LDPC) codes and high-order non-uniform 4096-QAM constellations based on non-uniform 64-PAM on each axis. The invention provides specific cyclic block permutations for interleaving bits of an LDPC codeword and specific non-uniform 64-PAM constellations for transmitting the interleaved codeword. The permutations and the non-uniform constellations have been jointly optimized for code rates of 6/15, 7/15, and 8/15.

# Fig. 2

EP 2 947 836 A1

**Description**

TECHNICAL FIELD

The present invention relates to the field of digital communications, and more specifically to bit interleavers and de-interleavers for bit-interleaved coding and modulation systems with quasi-cyclic low-density parity-check codes, and QAM modulation, as well as to corresponding methods, transmitters, and receivers.

BACKGROUND OF THE INVENTION

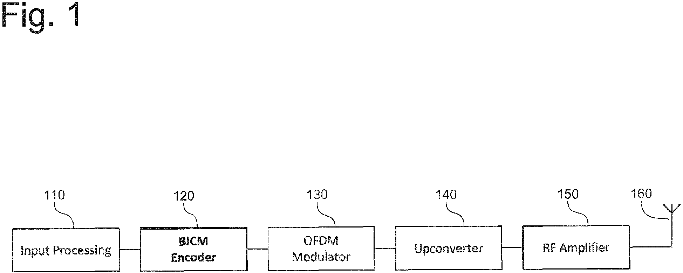

Figure 1 is a block diagram of a transmitter-side communication chain involving bit-interleaved coding and modulation (BICM). The input processing unit (110) formats the input bitstreams into blocks of a predetermined length called baseband frames. The BICM encoder (120) converts the baseband frames into a plurality of complex-valued data streams. Each stream is further processed by a chain comprising at least a modulator (130), an up-converter (140) from digital baseband to analog RF, and a radio-frequency RF power amplifier (150) for driving an antenna (160). The modulator (130) uses e.g. orthogonal frequency-division multiplexing (OFDM) modulation and typically includes time and frequency interleaving for increased diversity.

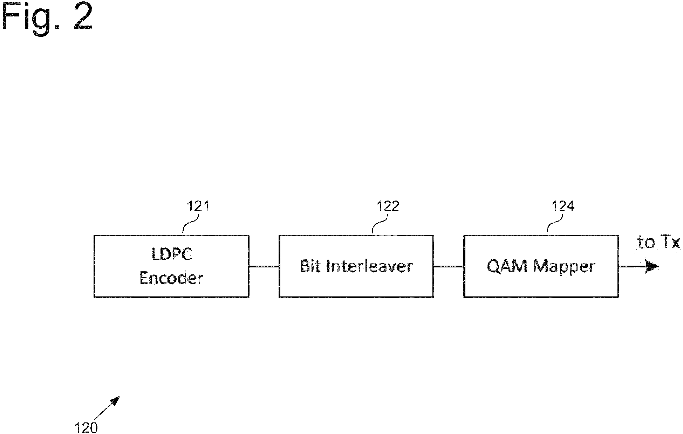

Figure 2 is the block diagram of a BICM encoder (120). The input blocks, i.e. baseband frames, are encoded by the low-density parity-check (LDPC) encoder (121) and fed to bit interleaver (122), which applies a permutation to the bits of each LDPC codeword before mapping them to complex cells by a constellation mapper (124), which employs quadrature amplitude modulation (QAM).

The components of the BICM encoder in Figure 2 will now be explained in more detail.

The LDPC encoder (121) encodes baseband frames according to a specified LDPC code. The present invention is specifically designed for LDPC block codes with staircase parity structure, as encountered in the DVB-S2, DVB-T2 and DVB-C2 standards, and variants as Raptor-like LDPC cpdes. More details will be given below.

An LDPC block code is a linear error-correcting code that is fully defined by its parity-check matrix (PCM), which is a binary sparse matrix that represents the connection of the codeword bits (also referred to as bit nodes or variable nodes) to the parity checks (also referred to as check nodes CN). The columns and the rows of the PCM correspond to the variable nodes and the check nodes, respectively. Connections of the variable nodes to the check nodes are represented by "1" entries in the PCM.

Quasi-cyclic (QC) LDPC codes have a structure that makes them particularly suitable for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row with one position, and can have one, two, or more folded diagonals.

The size of each circulant is QxQ, where Q is called the cyclic factor of the LDPC code. Such a quasi-cyclic structure allows Q check nodes to be processed in parallel, which is clearly advantageous for an efficient hardware implementation. The PCM of a quasi-cyclic LDPC code has therefore QM rows and QN columns, a codeword consisting of N blocks of Q bits. A Q-bit block is referred to as a quasi-cyclic block or simply cyclic block throughout this document and is abbreviated as QB.

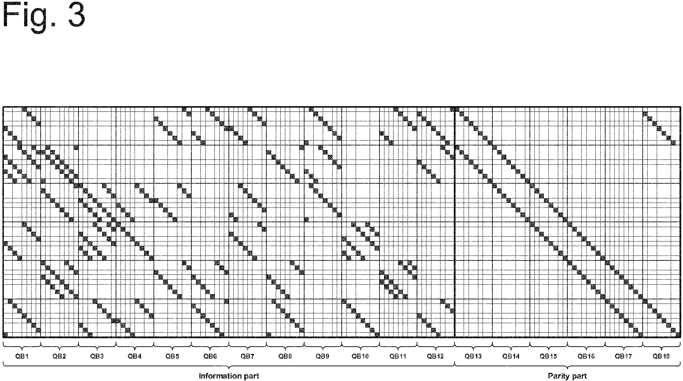

Figure 3 shows the PCM of an example LDPC code with M=6, N=18, and Q=8, the PCM having circulants with one or two diagonals. This code encodes a block of 8x12=96 bits to a codeword of 8x18=144 bits, having therefore a code rate of 2/3.

The code whose PCM is shown in Figure 3 belongs to a special family of QC LDPC codes called repeat-accumulate (RA) QC LDPC codes. These codes are well known for their ease of encoding and are encountered in a large number of standards, such as the second-generation DVB standards: DVB-S2, DVB-T2 and DVB-C2.

In the following, the definition of the repeat-accumulate quasi-cyclic LDPC codes used in the DVB-S2, DVB-T2 and DVB-C2 family of standards, as introduced in Section 5.3.2 and Annexes B and C of the DVB-S2 standard ETSI EN 302 307, V1.2.1 (August 2009), will be discussed. In this family of standards the cyclic factor Q is 360.

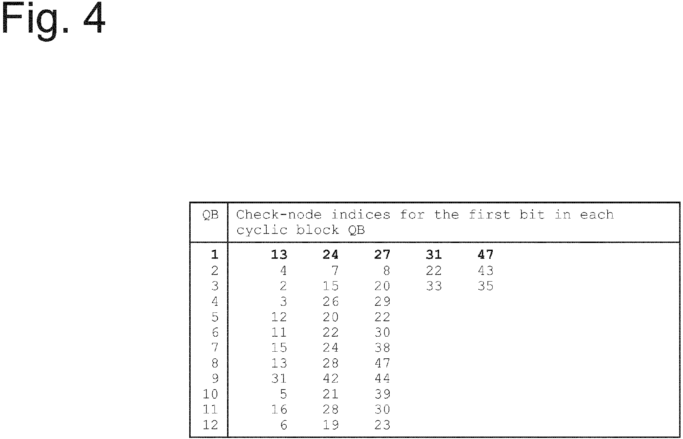

Each LDPC code is fully defined by a table that contains, for the first bit of each cyclic block in the information part, the zero-based indices of the check nodes the bit is connected to. These indices are referred to as "addresses of the parity bit accumulators" in the DVB-S2 standard. For the example LDPC code of Figure 3 this table is shown in Fig. 4.

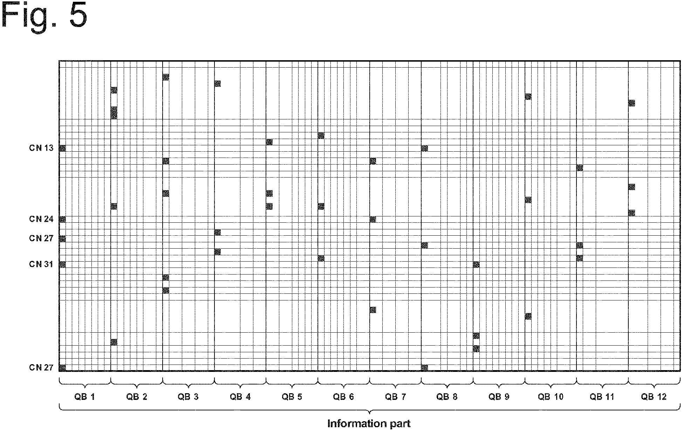

Figure 5 shows the information part of the parity-check matrix for the first bit in each cyclic block of the information part.

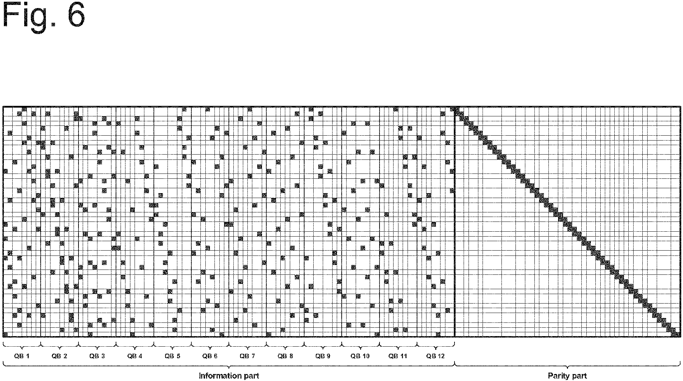

The full parity-check matrix, containing the entries for all information bits, as well as the staircase parity part, is shown in Figure 6.

For the other information bits, the CN indices are computed with the following formula:

$$i_q = (i_0 + q*M)\%(Q*M),$$

where q is the bit index (0...Q-1) within a cyclic block; iq is the CN index for bit q; $i_0$ is one of the CN indices in the table of Fig. 4; M is the number of cyclic blocks in the parity part, i.e. 6 in this example; Q*M is the number of parity bits, i.e. 48 in this example; and % denotes the modulo operator.

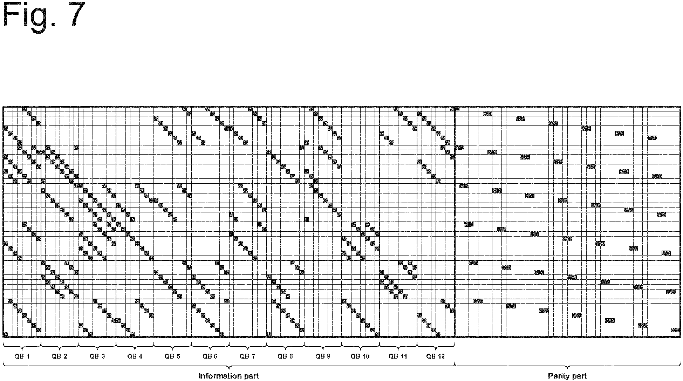

In order to reveal the quasi-cyclic structure of the parity-check matrix in Figure 6, the following permutation is applied to the rows of the matrix, the resulting matrix being shown in Figure 7:

$$j = (i\%M)*Q + floor(i/M)$$

where i and j are the zero-based indices of the non-permuted and the permuted CNs, respectively, and % denotes the modulo operator.

Since the permutation is not applied to the bits, the code definition does not change. The parity part of the resulting parity-check matrix is not quasi cyclic, however. In order to make it quasi cyclic, a special permutation must be applied to the parity bits only:

$$j = [i\%Q]*M + floor(i/Q)$$

where i and j are the zero-based indices of the non-permuted and permuted parity bits respectively.

This permutation changes the code definition and will be referred to as parity permutation or parity interleaving throughout this document. Moreover, this permutation will be regarded as part of the LDPC encoding process from now on.

The upcoming ATSC 3.0 standard for terrestrial reception of digital video services is currently under development and will define the following code rates: 1/15, 2/15,...,13/15 as well as codeword lengths 16200 and 64800 codebits.

QAM mapping

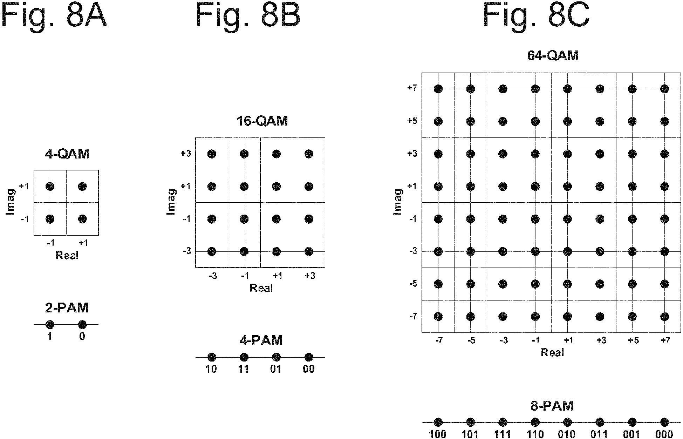

A QAM constellation is obtained by independently modulating the real and the imaginary components using pulse-amplitude modulatian (PAM), each point in the constellation corresponding to a unique combination of bits. Figures 8A-8C show the three types of QAM constellations relevant to the present invention: 4-QAM, 16-QAM, and 64-QAM, where the real and imaginary components have the same PAM modulation: 2-PAM, 4-PAM, and 8-PAM, respectively. The present invention also assumes that the PAM mapping has a Gray encoding, as shown in Figures 8A-8C.

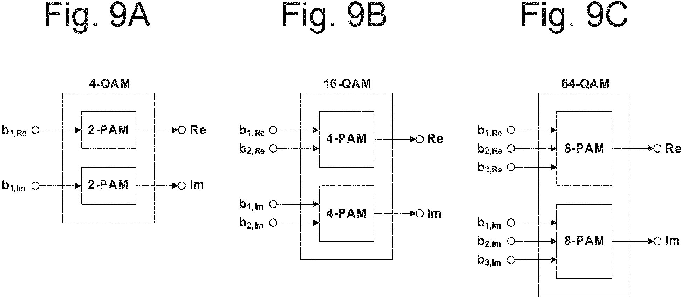

Figures 9A-9C show the corresponding QAM mappers for the three constellations. Each QAM mapper consists of two independent PAM mappers, each encoding the same number of bits.

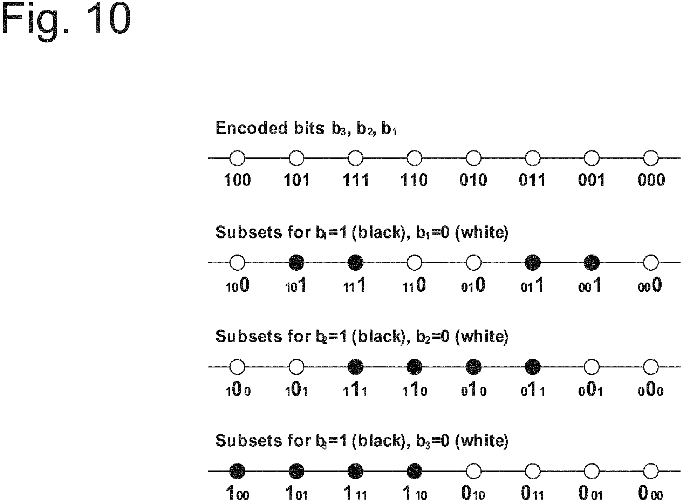

The bits encoded in a PAM symbol have different robustness levels (reliabilities) when the received PAM symbol is demapped in the receiver. This is a well known fact and is illustrated in Figure 10 for an 8-PAM symbol with Gray encoding. The different robustness levels result from the fact that the distance between the two partitions defined by a bit (0 or 1) is different for each of the three bits. The reliability of a bit is proportional to the average distance between the two partitions defined by that bit. In the example shown in Figure 10, bits b1, b2, b3 have increasing reliabilities.

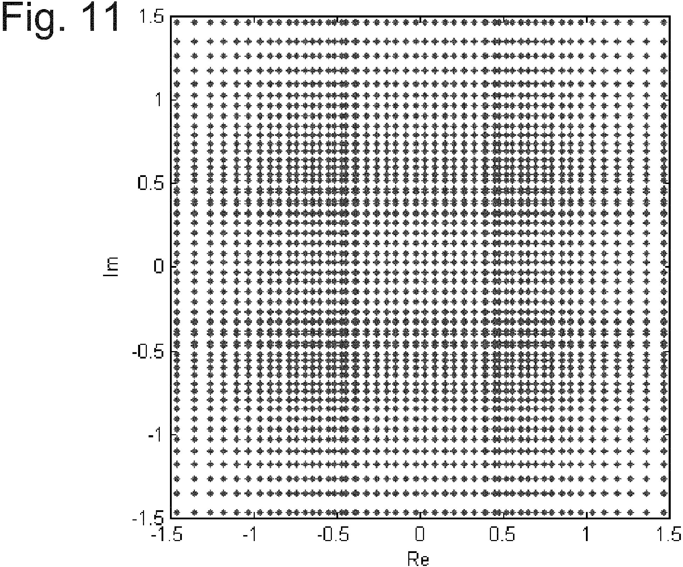

To increase the rate at which bits are transmitted, i.e., the BICM capacity, non-uniform constellations have been introduced in DVB-NGH for the first time. This increase is achieved by varying the spacing between the PAM constellation points, resulting in so called 1D-NU-PAMs, which in turn result in rectangular non-uniform constellation. In ATSC 3.0, this idea is further improved by introducing 2D non-uniform constellations, so called 2D-NUCs. The latter entail increased demapping complexity at the receiver since I- and Q-components of the received cells are now dependent. Higher demapping complexity is deemed acceptable within ATSC 3.0 up to a constellation order of 1024. Beyond that it was decided to allow only PAM based constellations for 4096 QAM constellations. An example constellation for a 4096-QAM based on 1 D-64 NU-PAM is depicted in Figure 11.

The number of bits in a QAM symbol is denoted by B. Since the QAM constellations are square, B is even. Moreover, since a square QAM symbol consists of two identical PAM symbols, the bits encoded in a QAM symbol can be grouped in pairs having the same robustness. In the following, the bits encoded in a QAM constellation will be referred to as a constellation word.

Bit interleaver

Typically, the bits of an LDPC codeword have different importance levels, and the bits of a constellation have different robustness levels. A direct, i.e. non-interleaved, mapping of the LDPC codeword bits to the QAM constellation bits leads to a suboptimal performance. In order to avoid such performance degradation the codeword bits need to be interleaved prior to being mapped onto constellations. For this purpose, a bit interleaver 122 is used between the LDPC encoder 121 and the QAM constellation mapper 124, as illustrated in Figure 2. By carefully designing the interleaver, an optimum association can be achieved between the bits of the LDPC codeword and the bits encoded by the constellation, leading to an improved performance. A typical measure of the performance is the bit-error rate (BER) or the frame-error rate (FER) as a function of the signal-to-noise ratio (SNR).

The different importance levels of the bits of an LDPC codeword result primarily from the fact that not all the bits are involved in the same number of parity checks. The more parity checks (check nodes) a codeword bit (variable node) is involved in, the more important that bit is in the iterative LDPC decoding process. A further reason is the fact that the variable nodes have different connectivities to the cycles in the Tanner graph representation of the LDPC code, so they may still have different importance levels even when they are involved in the same number of parity checks. These aspects are well understood in the art. As a general rule, the importance level of a variable node increases with the number of check nodes it is connected to.

In the particular case of quasi-cyclic LDPC codes, all bits in a cyclic block of Q bits have the same importance since all of them are involved in the same number of parity checks and have the same connectivity to the cycles in the Tanner graph.

In the following, a method for mapping the bits of a quasi-cyclic LDPC codeword to constellation words is described. This mapping is performed by bit interleaver 122 in Figure 2. The method is introduced in co-pending application EP 11 006 087.8, which is incorporated herewith in its entirety, for a generic number T of transmit antennas and will be explained in the following for the case relevant to the present invention, i.e. for T=1 transmit antennas. The present invention is specifically optimized for and works in conjunction with such a mapping.

According to co-pending application EP 11 006 087.8, the bits of a quasi-cyclic LDPC codeword are mapped to constellation words such that (i) each constellation word is made up of bits from B/2 different cyclic blocks of the codeword, and (ii) each pair of constellation word bits that are encoded in the same QAM symbol and have the same robustness is made up of bits from the same cyclic block.

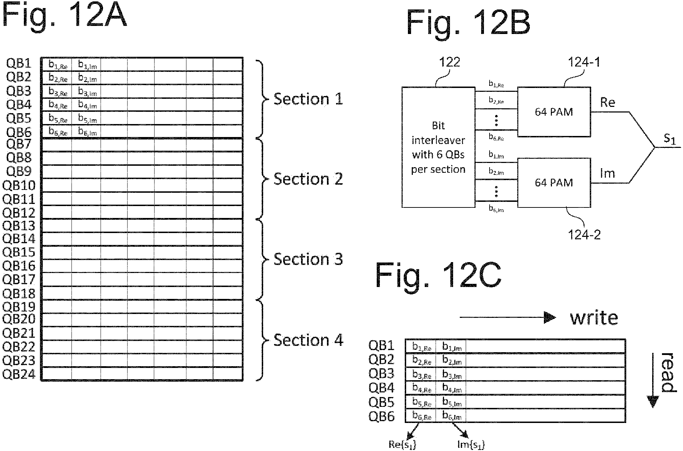

Specifically, the Q·B/2 bits of the B/2 cyclic blocks are mapped to Q/2 spatial-multiplexing blocks. In this case, the B/2 cyclic blocks are referred to as a section. Such a configuration is illustrated in Figs. 12A with four sections and 24 cyclic blocks.

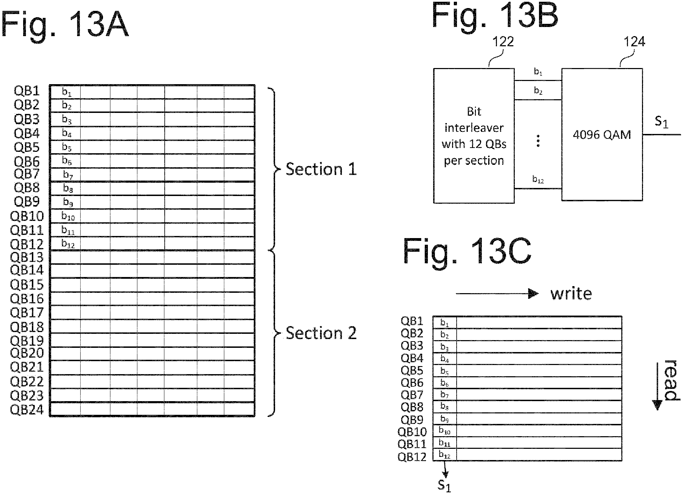

Figure 12B shows a specific configuration of the bit interleaver and the QAM mapper pathway of the BICM encoder of Fig. 2 according to DVB-NGH. Specifically, the LDPC codeword generated by LDPC encoder 121 in Fig. 2 is fed to bit interleaver 122 in Fig. 13. The bits of the permuted codeword are then allocated to the real and the imaginary parts of the corresponding constellation words. These bits ($b_{1,Re}$, $b_{1,Im}$, ...) are then mapped to a complex symbol (Re, Im) by means of a pair of PAM mappers (124-1, 124-2).

Figure 12C shows a representation of the reordering performed by the bit interleaver 122. As it is illustrated in Fig. 12C, all bits of the codeword are written row-by-row into a matrix, from where they are read in a column-by-column fashion.

Figures 13A to 13C illustrate another specific configuration of the bit interleaver and the QAM mapper pathway of the BICM encoder of Fig. 2. Figs. 13A to 13C are similar to Figs. 12A to 12C, respectively, except that these figures illustrate the configuration of the bit interleaver and the QAM mapper pathway of the BICM encoder according to ATSC 3.0.

SUMMARY OF THE INVENTION

It is an object of the present invention to improve the performance of communication systems that employ quasi-cyclic LDPC codes and high order constellations.

This is achieved by the features as set forth in the independent claims.

Preferred embodiments are the subject matter of dependent claims.

It is the particular approach of the present invention to select a specifically optimized quasi-cyclic block permutation and/or a specifically optimized non-uniform constellation on the basis of the code rate of the quasi-cyclic LDPC code that is employed for communicating data in a digital communication system.

According to a first aspect of the present invention, a method for communicating data in a digital communication system employing a quasi-cyclic low-density parity-check code is provided. The method comprises an interleaving step for applying a cyclic block permutation to a codeword of the quasi-cyclic low-density parity-check code, the codeword consisting of a sequence of N cyclic blocks, each cyclic block consisting of Q bits, N and Q being positive integers, the cyclic block permutation being configured for permuting the sequence of cyclic blocks within the codeword; and a constellation mapping or de-mapping step for mapping bits of the permuted codeword to constellation points of a non-uniform constellation, or vice versa, the non-uniform constellation and the cyclic-block permutation being selected on the basis of a code rate of the employed quasi-cyclic low-density parity-check code.

In a preferred embodiment, the quasi-cyclic low-density parity-check code has a code rate of 6/15 and the selected cyclic-block permutation or its inverse is defined according to Table 1 and/or the selected non-uniform constellation is a non-uniform 4096-QAM constellation having real and complex coordinates given by non-uniform 64-PAM according to Table 2.

In another preferred embodiment, the quasi-cyclic low-density parity-check code has a code rate of 7/15 and the selected cyclic-block permutation or its inverse is defined according to Table 3 and/or the selected non-uniform constellation is a non-uniform 4096-QAM constellation having real and complex coordinates given by non-uniform 64-PAM according to Table 4.

In another preferred embodiment, the quasi-cyclic low-density parity-check code has a code rate of 8/15 and the selected cyclic-block permutation or its inverse is defined according to Table 5 and/or the selected non-uniform constellation is a non-uniform 4096-QAM constellation having real and complex coordinates given by non-uniform 64-PAM according to Table 6.

In a preferred embodiment, the number of cyclic blocks equals 180 and the number of bits per cyclic block equals 360.

In a preferred embodiment, the method further comprises the step of selecting the employed quasi-cyclic low-density parity-check code from a plurality of predefined quasi-cyclic low-density parity-check codes, each of the predefined quasi-cyclic low-density parity-check codes having a distinct code rate.

According to a second aspect of the present invention, a transmitter of a digital communication system is provided, which is adapted for transmitting data by performing all steps of a method according to the first aspect.

According to a third aspect of the present invention, a receiver of a digital communication system is provided, which is adapted for receiving data by performing all steps of a method according to the first aspect.

The above and other objects and features of the present invention will become more apparent from the following description and preferred embodiments given in conjunction with the accompanying drawings, in which:

Fig. 1             is a block diagram of a transmitter-side communication chain involving bit-interleaved coding and modulation;

Fig. 2             is a block diagram of a bit-interleaved coding and modulation encoder;

Fig. 3             shows the parity check matrix of an exemplary LDPC code with cyclic factor Q=8;

Fig. 4             is a table with an examplary repeat-accumulate LDPC code definition;

Fig. 5             shows the information part of the parity-check matrix for the LDPC code of Fig. 4 for the first bit in each cyclic block of the information part;

Fig. 6             shows the full parity-check matrix of Fig. 5, containing the entries for all information bits, as well as the staircase parity part;

Fig. 7             shows the quasi-cyclic structure of the parity-check matrix of Fig. 6;

Figs. 8A           to 8C illustrate a 4-QAM constellation, a 16-QAM constellation, and a 64-QAM constellation, respectively;

Figs. 9A to 9C     show a block diagram of a 4-QAM (QPSK) constellation mapper, a 16-QAM constellation mapper, and a 64-QAM constellation mapper, respectively;

Fig. 10            is a schematic illustration of the different robustness levels in a 8-PAM symbol with Gray encoding;

Fig. 11            is a schematic illustration of an example constellation for 4096-QAM based on 1 D-64 NU-PAM designed for a specific SNR;

Fig. 12A to 12C    are schematic representations of specific configurations of the bit-interleaving coding and modulation encoder of Fig. 2 according to DVB-NGH.

Figs. 13A to 13C   are schematic representations of specific configurations of the bit-interleaving coding and modulation encoder of Fig. 2 according to ATSC 3.0.

Figs. 14            shows a structural representation of a bit interleaver according to an embodiment of the present invention;

DETAILED DESCRIPTION

The present invention provides a bit interleaver that ensures that the B bits of each QAM symbol are mapped to exactly B/2 cyclic blocks of the quasi-cyclic LDPC codeword in such a way that each of the B/2 cyclic blocks is associated with bits of the same robustness. In other words, each constellation word is made up of bits from B/2 different cyclic blocks of the codeword and each pair of constellation word bits that have the same robustness is made up of bits from the same cyclic block.

As already mentioned above, different cyclic blocks of a given LDPC code may have different importance levels, depending on the number of check nodes to which they are connected. Therefore, transmission performance may be improved by matching the importance of the cyclic blocks and the robustness of the constellation word bits to which they are mapped. Specifically, the bits of cyclic blocks having the highest importance are mapped to constellation word bits having the highest robustness. Conversely, bits of cyclic blocks having the lowest importance are mapped to constellation word bits having the lowest robustness.

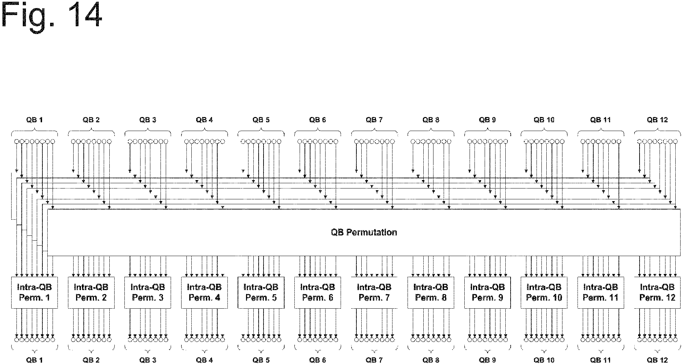

Fig. 14 shows a structural representation of a bit interleaver according to an embodiment of the present invention. In the example shown, an LDPC codeword consists of N=12 cyclic blocks QB1, ..., QB12 with Q=8 bits each.

The bit interleaving process may comprise two stages. In a first stage, a cyclic block permutation (QB permutation) is applied to the codeword in order to rearrange the sequence of the cyclic blocks, without affecting the sequence of the bits within each cyclic block. In a second stage, the bits of the shuffled cyclic blocks are mapped to the constellation words. The latter step can be implemented by dividing the codeword into a plurality of sections and performing the mapping to the constellation words on a section-by-section basis ("section permutation"). Each section is preferably made up of B/2 cyclic blocks such that the above conditions can be met.

The inventor has realized that the performance of the communication system can be improved for a given LDPC code by optimizing the cyclic block permutation, i.e., by choosing a cyclic block permutation that matches constellation bits of different reliabilities with cyclic blocks of different importance levels.

The mapping of cyclic blocks to constellation word bits, however, is not straightforward. Finding optimized cyclic block permutations is a very time-consuming process as no analytical solutions are known so far. The method used for finding the optimized cyclic block permutations disclosed in the present invention consists of the following steps, which are applied for each of the different constellations and code rates.

In a preliminary step, a huge number (1 e4...1 e5) of unconstrained random QB permutations are generated. For these permutations, Monte-Carlo simulations are performed with blind and iterative demapping in order to determine the threshold SNR (signal-to-noise ratio) at a given target BLER (block error rate). The permutation that has the lowest threshold SNR, i.e. the best performance, is kept.

The inventor discovered that optimizing the QB permutation for blind demapping results in suboptimal performance with iterative demapping and vice versa. Finding permutations that are good for both types of demapping remains a challenging task.

It is therefore an object of the present invention to present QB permutations that have good performance with both blind and iterative demapping.

From the preliminary step, the SNR range for various QB permutations can be determined. Then, a threshold SNR is set in order to select only permutations that have good performance with blind demapping. Good performance means low SNR. The threshold should not be set too low since that will exclude many permutations that are very good with iterative demapping. Besides, permutations that are heavily optimized for blind demapping perform badly with iterative demapping. Selecting the initial threshold SNR appropriately is a question of experience.

In a first selection step, a large number of unconstrained random QB permutations is generated. For each permutation, the corresponding BLER curve is determined, e.g. through Monte-Carlo simulations, and only the permutations with a SNR at the target BLER lower than the defined threshold SNR are kept. For the surviving permutations, the BLER curves with iterative demapping are determined and the best permutation is kept.

In a second selection step, a medium number of constrained random permutations derived from the permutation returned by the first selection step is generated, and the selection criterion from the first selection step is applied. The constrained permutations are derived by applying a random permutation to the cyclic blocks of a single randomly selected section. Applying such a constraint ensures that the variations in performance are small and concentrated around the already good permutation selected in the first step. In this manner, better permutations can be found more efficiently than by using a blind unconstrained search.

In a third selection step, a medium number of constrained random permutations is derived from the permutation returned by the second selection step and the selection criterion from the first selection step is applied. The constrained permutations are derived by applying random permutations to bits having the same robustness level. Therefore, variations in performance are rather small and affect the iterative demapping more than the blind demapping. The performance with iterative demapping can therefore be optimized without sacrificing the performance with blind demapping.

Optimizations have been performed for code rates of 6/15, 7/15, and 8/15. Simultaneous to optimizing the permutations, the optimum non-uniform constellations to be used in conjunction with code rates of 6/15, 7/15, and 8/15 have been determined as well. Results of the optimization are disclosed herebelow.

Tables 1 and 2 disclose the optimized cyclic block permutation and the non-uniform OAM constellation according to the present invention for a code rate of 6/15.

**Table 1: QB permutation for code rate 6/15**

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 42 | 45 | 175 | 90 | 2 | 135 | 24 |
| 1 | 46 | 46 | 36 | 91 | 127 | 136 | 126 |
| 2 | 135 | 47 | 138 | 92 | 69 | 137 | 58 |
| 3 | 82 | 48 | 100 | 93 | 56 | 138 | 96 |
| 4 | 17 | 49 | 4 | 94 | 176 | 139 | 49 |
| 5 | 50 | 50 | 11 | 95 | 54 | 140 | 170 |
| 6 | 131 | 51 | 168 | 96 | 31 | 141 | 162 |
| 7 | 65 | 52 | 40 | 97 | 38 | 142 | 71 |
| 8 | 145 | 53 | 105 | 98 | 45 | 143 | 85 |
| 9 | 164 | 54 | 103 | 99 | 132 | 144 | 6 |
| 10 | 1 | 55 | 20 | 100 | 118 | 145 | 102 |
| 11 | 141 | 56 | 152 | 101 | 98 | 146 | 114 |
| 12 | 179 | 57 | 171 | 102 | 83 | 147 | 99 |
| 13 | 130 | 58 | 155 | 103 | 13 | 148 | 62 |
| 14 | 81 | 59 | 93 | 104 | 30 | 149 | 115 |
| 15 | 52 | 60 | 66 | 105 | 149 | 150 | 109 |
| 16 | 142 | 61 | 48 | 106 | 86 | 151 | 122 |
| 17 | 108 | 62 | 124 | 107 | 57 | 152 | 148 |
| 18 | 116 | 63 | 12 | 108 | 22 | 153 | 92 |
| 19 | 174 | 64 | 113 | 109 | 143 | 154 | 106 |
| 20 | 47 | 65 | 73 | 110 | 90 | 155 | 137 |
| 21 | 44 | 66 | 139 | 111 | 34 | 156 | 125 |
| 22 | 157 | 67 | 104 | 112 | 35 | 157 | 129 |
| 23 | 64 | 68 | 107 | 113 | 88 | 158 | 153 |

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 24 | 27 | 69 | 37 | 114 | 79 | 159 | 15 |
| 25 | 144 | 70 | 76 | 115 | 80 | 160 | 33 |
| 26 | 120 | 71 | 72 | 116 | 75 | 161 | 89 |
| 27 | 41 | 72 | 110 | 117 | 0 | 162 | 97 |
| 28 | 91 | 73 | 154 | 118 | 146 | 163 | 8 |
| 29 | 84 | 74 | 10 | 119 | 112 | 164 | 167 |
| 30 | 29 | 75 | 43 | 120 | 67 | 165 | 177 |
| 31 | 169 | 76 | 18 | 121 | 63 | 166 | 9 |
| 32 | 156 | 77 | 78 | 122 | 77 | 167 | 172 |
| 33 | 123 | 78 | 151 | 123 | 136 | 168 | 25 |
| 34 | 53 | 79 | 16 | 124 | 51 | 169 | 26 |
| 35 | 21 | 80 | 70 | 125 | 14 | 170 | 133 |
| 36 | 121 | 81 | 7 | 126 | 60 | 171 | 101 |
| 37 | 94 | 82 | 140 | 127 | 59 | 172 | 166 |
| 38 | 147 | 83 | 87 | 128 | 39 | 173 | 32 |
| 39 | 159 | 84 | 23 | 129 | 128 | 174 | 111 |
| 40 | 117 | 85 | 68 | 130 | 74 | 175 | 61 |
| 41 | 163 | 86 | 3 | 131 | 119 | 176 | 28 |
| 42 | 178 | 87 | 19 | 132 | 150 | 177 | 160 |
| 43 | 55 | 88 | 134 | 133 | 158 | 178 | 165 |
| 44 | 173 | 89 | 161 | 134 | 5 | 179 | 95 |

**Table 2: PAM constellation for code rate 6/15**

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | 1,7263 | 16 | 0,1107 | 32 | -1,7263 | 48 | -0,1107 |
| 1 | 1,4611 | 17 | 0,111 | 33 | -1,4611 | 49 | -0,111 |
| 2 | 1,1929 | 18 | 0,1099 | 34 | -1,1929 | 50 | -0,1099 |
| 3 | 1,2504 | 19 | 0,11 | 35 | -1,2504 | 51 | -0,11 |
| 4 | 0,9179 | 20 | 0,1161 | 36 | -0,9179 | 52 | -0,1161 |
| 5 | 0,9107 | 21 | 0,1166 | 37 | -0,9107 | 53 | -0,1166 |
| 6 | 0,9856 | 22 | 0,1157 | 38 | -0,9856 | 54 | -0,1157 |
| 7 | 0,972 | 23 | 0,1158 | 39 | -0,972 | 55 | -0,1158 |
| 8 | 0,5891 | 24 | 0,3626 | 40 | -0,5891 | 56 | -0,3626 |
| 9 | 0,5902 | 25 | 0,3619 | 41 | -0,5902 | 57 | -0,3619 |
| 10 | 0,5809 | 26 | 0,366 | 42 | -0,5809 | 58 | -0,366 |
| 11 | 0,5821 | 27 | 0,3659 | 43 | -0,5821 | 59 | -0,3659 |
| 12 | 0,6911 | 28 | 0,3341 | 44 | -0,6911 | 60 | -0,3341 |
| 13 | 0,6944 | 29 | 0,3333 | 45 | -0,6944 | 61 | -0,3333 |
| 14 | 0,6678 | 30 | 0,3374 | 46 | -0,6678 | 62 | -0,3374 |
| 15 | 0,6709 | 31 | 0,3368 | 47 | -0,6709 | 63 | -0,3368 |

Tables 3 and 4 disclose the optimized cyclic block permutation and the non-uniform OAM constellation according to the present invention for a code rate of 7/15.

**Table 3: QB permutation for code rate 7/15**

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 59 | 45 | 101 | 90 | 138 | 135 | 24 |
| 1 | 122 | 46 | 4 | 91 | 51 | 136 | 117 |
| 2 | 161 | 47 | 5 | 92 | 89 | 137 | 154 |
| 3 | 93 | 48 | 87 | 93 | 88 | 138 | 157 |
| 4 | 37 | 49 | 106 | 94 | 167 | 139 | 164 |
| 5 | 112 | 50 | 79 | 95 | 80 | 140 | 143 |
| 6 | 111 | 51 | 104 | 96 | 142 | 141 | 12 |
| 7 | 62 | 52 | 168 | 97 | 108 | 142 | 56 |
| 8 | 42 | 53 | 163 | 98 | 69 | 143 | 152 |
| 9 | 102 | 54 | 170 | 99 | 7 | 144 | 20 |
| 10 | 119 | 55 | 57 | 100 | 103 | 145 | 85 |
| 11 | 72 | 56 | 83 | 101 | 115 | 146 | 84 |
| 12 | 60 | 57 | 44 | 102 | 99 | 147 | 77 |
| 13 | 144 | 58 | 54 | 103 | 135 | 148 | 158 |
| 14 | 34 | 59 | 110 | 104 | 36 | 149 | 107 |
| 15 | 120 | 60 | 30 | 105 | 11 | 150 | 32 |
| 16 | 46 | 61 | 50 | 106 | 166 | 151 | 153 |
| 17 | 31 | 62 | 82 | 107 | 169 | 152 | 147 |
| 18 | 129 | 63 | 10 | 108 | 8 | 153 | 132 |
| 19 | 172 | 64 | 148 | 109 | 165 | 154 | 124 |
| 20 | 149 | 65 | 98 | 110 | 68 | 155 | 52 |
| 21 | 94 | 66 | 41 | 111 | 173 | 156 | 121 |
| 22 | 65 | 67 | 22 | 112 | 140 | 157 | 58 |
| 23 | 9 | 68 | 96 | 113 | 95 | 158 | 118 |

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 24 | 0 | 69 | 49 | 114 | 179 | 159 | 137 |
| 25 | 76 | 70 | 90 | 115 | 2 | 160 | 114 |
| 26 | 13 | 71 | 100 | 116 | 125 | 161 | 97 |
| 27 | 61 | 72 | 29 | 117 | 105 | 162 | 19 |
| 28 | 3 | 73 | 39 | 118 | 1 | 163 | 155 |
| 29 | 70 | 74 | 175 | 119 | 116 | 164 | 67 |
| 30 | 40 | 75 | 38 | 120 | 150 | 165 | 25 |
| 31 | 78 | 76 | 109 | 121 | 174 | 166 | 17 |
| 32 | 127 | 77 | 91 | 122 | 15 | 167 | 126 |
| 33 | 35 | 78 | 74 | 123 | 75 | 168 | 23 |
| 34 | 145 | 79 | 159 | 124 | 64 | 169 | 43 |
| 35 | 28 | 80 | 139 | 125 | 176 | 170 | 27 |
| 36 | 48 | 81 | 177 | 126 | 81 | 171 | 21 |
| 37 | 162 | 82 | 71 | 127 | 55 | 172 | 136 |
| 38 | 92 | 83 | 47 | 128 | 130 | 173 | 131 |
| 39 | 73 | 84 | 146 | 129 | 151 | 174 | 26 |
| 40 | 6 | 85 | 63 | 130 | 156 | 175 | 14 |
| 41 | 134 | 86 | 86 | 131 | 53 | 176 | 18 |
| 42 | 66 | 87 | 45 | 132 | 171 | 177 | 128 |
| 43 | 160 | 88 | 123 | 133 | 16 | 178 | 141 |
| 44 | 133 | 89 | 33 | 134 | 113 | 179 | 178 |

**Table 4: PAM constellation for code rate 7/15**

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | 1,6851 | 16 | 0,081 | 32 | -1,6851 | 48 | -0,081 |
| 1 | 1,4381 | 17 | 0,0808 | 33 | -1,4381 | 49 | -0,0808 |
| 2 | 1,1766 | 18 | 0,081 | 34 | -1,1766 | 50 | -0,081 |
| 3 | 1,2355 | 19 | 0,0807 | 35 | -1,2355 | 51 | -0,0807 |
| 4 | 0,9162 | 20 | 0,1456 | 36 | -0,9162 | 52 | -0,1456 |
| 5 | 0,9089 | 21 | 0,1456 | 37 | -0,9089 | 53 | -0,1456 |
| 6 | 1,0012 | 22 | 0,1456 | 38 | -1,0012 | 54 | -0,1456 |
| 7 | 0,9771 | 23 | 0,1457 | 39 | -0,9771 | 55 | -0,1457 |
| 8 | 0,5684 | 24 | 0,4036 | 40 | -0,5684 | 56 | -0,4036 |
| 9 | 0,5681 | 25 | 0,4036 | 41 | -0,5681 | 57 | -0,4036 |
| 10 | 0,5704 | 26 | 0,4043 | 42 | -0,5704 | 58 | -0,4043 |
| 11 | 0,57 | 27 | 0,4042 | 43 | -0,57 | 59 | -0,4042 |
| 12 | 0,7385 | 28 | 0,3059 | 44 | -0,7385 | 60 | -0,3059 |
| 13 | 0,7425 | 29 | 0,306 | 45 | -0,7425 | 61 | -0,306 |
| 14 | 0,7155 | 30 | 0,3056 | 46 | -0,7155 | 62 | -0,3056 |
| 15 | 0,7186 | 31 | 0,3057 | 47 | -0,7186 | 63 | -0,3057 |

Tables 5 and 6 disclose the optimized cyclic block permutation and the non-uniform OAM constellation according to the present invention for a code rate of 8/15.

**Table 5: QB permutation for code rate 8/15**

| j-th block of Group-wise Interleaver output | $\pi(j)$-th block of Group-wise Interleaver input | j-th block of Group-wise Interleaver output | (j)-th block of Group-wise Interleaver input | j-th block of Group-wise Interleaver output | $\pi(j)$-th block of Group-wise Interleaver input | j-th block of Group-wise Interleaver output | $\pi(j)$-th block of Group-wise Interleaver input |
|---|---|---|---|---|---|---|---|
| 0 | 82 | 45 | 161 | 90 | 56 | 135 | 166 |
| 1 | 75 | 46 | 69 | 91 | 144 | 136 | 16 |
| 2 | 51 | 47 | 8 | 92 | 74 | 137 | 131 |
| 3 | 24 | 48 | 156 | 93 | 89 | 138 | 105 |
| 4 | 96 | 49 | 52 | 94 | 14 | 139 | 159 |
| 5 | 80 | 50 | 45 | 95 | 107 | 140 | 0 |
| 6 | 152 | 51 | 27 | 96 | 37 | 141 | 136 |
| 7 | 118 | 52 | 154 | 97 | 113 | 142 | 115 |
| 8 | 147 | 53 | 129 | 98 | 44 | 143 | 122 |
| 9 | 169 | 54 | 4 | 99 | 19 | 144 | 117 |
| 10 | 64 | 55 | 38 | 100 | 17 | 145 | 62 |
| 11 | 106 | 56 | 177 | 101 | 35 | 146 | 3 |
| 12 | 60 | 57 | 127 | 102 | 88 | 147 | 178 |
| 13 | 22 | 58 | 49 | 103 | 101 | 148 | 57 |
| 14 | 65 | 59 | 167 | 104 | 28 | 149 | 59 |
| 15 | 46 | 60 | 120 | 105 | 63 | 150 | 179 |
| 16 | 79 | 61 | 100 | 106 | 108 | 151 | 7 |
| 17 | 140 | 62 | 12 | 107 | 109 | 152 | 20 |
| 18 | 133 | 63 | 173 | 108 | 10 | 153 | 34 |
| 19 | 135 | 64 | 84 | 109 | 175 | 154 | 32 |
| 20 | 18 | 65 | 112 | 110 | 160 | 155 | 150 |
| 21 | 171 | 66 | 121 | 111 | 119 | 156 | 174 |
| 22 | 15 | 67 | 151 | 112 | 94 | 157 | 172 |
| 23 | 87 | 68 | 23 | 113 | 39 | 158 | 165 |

14

| j-th block of Group-wise Interleaver output | $\pi$(j)-th block of Group-wise Interleaver input | j-th block of Group-wise Interleaver output | (j)-th block of Group-wise Interleaver input | j-th block of Group-wise Interleaver output | $\pi$(j)-th block of Group-wise Interleaver input | j-th block of Group-wise Interleaver output | $\pi$(j)-th block of Group-wise Interleaver input |
|---|---|---|---|---|---|---|---|
| 24 | 90 | 69 | 92 | 114 | 99 | 159 | 68 |
| 25 | 5 | 70 | 146 | 115 | 40 | 160 | 85 |
| 26 | 170 | 71 | 67 | 116 | 134 | 161 | 55 |
| 27 | 42 | 72 | 43 | 117 | 21 | 162 | 114 |
| 28 | 9 | 73 | 158 | 118 | 83 | 163 | 176 |
| 29 | 86 | 74 | 1 | 119 | 58 | 164 | 71 |
| 30 | 132 | 75 | 103 | 120 | 13 | 165 | 66 |
| 31 | 162 | 76 | 141 | 121 | 53 | 166 | 128 |
| 32 | 142 | 77 | 48 | 122 | 26 | 167 | 116 |
| 33 | 93 | 78 | 25 | 123 | 126 | 168 | 163 |
| 34 | 104 | 79 | 50 | 124 | 6 | 169 | 145 |
| 35 | 138 | 80 | 29 | 125 | 47 | 170 | 153 |
| 36 | 102 | 81 | 77 | 126 | 76 | 171 | 139 |
| 37 | 168 | 82 | 124 | 127 | 41 | 172 | 97 |
| 38 | 54 | 83 | 110 | 128 | 11 | 173 | 30 |
| 39 | 78 | 84 | 70 | 129 | 98 | 174 | 157 |
| 40 | 111 | 85 | 33 | 130 | 61 | 175 | 149 |
| 41 | 164 | 86 | 125 | 131 | 73 | 176 | 155 |
| 42 | 95 | 87 | 2 | 132 | 148 | 177 | 72 |
| 43 | 31 | 88 | 91 | 133 | 36 | 178 | 81 |
| 44 | 137 | 89 | 130 | 134 | 143 | 179 | 123 |

**Table 6: PAM constellation for code rate 8/15**

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | 1,6651 | 16 | 0,0695 | 32 | -1,6651 | 48 | -0,0695 |
| 1 | 1,4272 | 17 | 0,0694 | 33 | -1,4272 | 49 | -0,0694 |
| 2 | 1,1713 | 18 | 0,0696 | 34 | -1,1713 | 50 | -0,0696 |
| 3 | 1,2329 | 19 | 0,0697 | 35 | -1,2329 | 51 | -0,0697 |
| 4 | 0,9125 | 20 | 0,1629 | 36 | -0,9125 | 52 | -0,1629 |
| 5 | 0,9069 | 21 | 0,1629 | 37 | -0,9069 | 53 | -0,1629 |
| 6 | 1,0081 | 22 | 0,1629 | 38 | -1,0081 | 54 | -0,1629 |
| 7 | 0,9831 | 23 | 0,163 | 39 | -0,9831 | 55 | -0,163 |
| 8 | 0,5697 | 24 | 0,4194 | 40 | -0,5697 | 56 | -0,4194 |
| 9 | 0,5694 | 25 | 0,4196 | 41 | -0,5694 | 57 | -0,4196 |
| 10 | 0,5739 | 26 | 0,4196 | 42 | -0,5739 | 58 | -0,4196 |
| 11 | 0,5733 | 27 | 0,4195 | 43 | -0,5733 | 59 | -0,4195 |
| 12 | 0,7459 | 28 | 0,3034 | 44 | -0,7459 | 60 | -0,3034 |
| 13 | 0,7496 | 29 | 0,3035 | 45 | -0,7496 | 61 | -0,3035 |
| 14 | 0,7192 | 30 | 0,3032 | 46 | -0,7192 | 62 | -0,3032 |
| 15 | 0,7216 | 31 | 0,3032 | 47 | -0,7216 | 63 | -0,3032 |

Mapping on cells is achieved by computing s=p(x')+j·p(x"), wherein non-uniform PAM coordinates p(x) are taken from Table 2 for code rate 6/15, from Table 4 for code rate 7/15, and from Table 6 for code rate 8/15. The address labels for the real part, x', are computed based on the even numbered bits from the section interleaver output $b_0$, $b_2$, $b_4$, $b_8$, $b_{10}$:

$$x' = \sum_{i=0}^{5} 2^{5-i} b_{2i} ,$$

whereas address labels for the imaginary part, x", are computed based on the odd numbered bits $b_1$, $b_3$, $b_5$, $b_7$, $b_9$, $b_{11}$:

$$x" = \sum_{i=0}^{5} 2^{5-i} b_{2i+1} .$$

The above described cyclic-block permutations and constellations are relevant for both the transmitter side and the receiver side in a digital communication system. Each of the above permutations uniquely defines also its inverse permutation, either one of which is used at the transmitter side for bit interleaving or at the receiver side for bit de-interleaving. Further, the above definitions of 2D non-uniform constellations form the basis for mapping constellation words, i.e., bits of the codeword, onto complex cells used for transmission, as well for demapping the complex cells received at the other end of the communication channel.

The above described cyclic-block permutations and constellations have been optimized for two specific LDPC codes with a code rate of 6/15, 7/15, and 8/15, respectively. The LDPC code with code rate of 6/15 and 7/15 is defined by way of the following algorithm:

An LDPC code is used to encode the information block $S = (s_0, s_1, ... s_{k-1})$ to generate a codeword A = $(\lambda_0, \lambda_1 ... \lambda_{N-1})$ of length $N = K + M_1 + M_2$:

$$\Lambda = \left(s_0, s_1, \ldots s_{K-1}, p_0, p_1, \ldots, p_{M_1 + M_2 - 1}\right)$$

For code rate 6/15: M1=1080, M2=37800, Q1=3, Q2=105
For code rate 7/15: M1=1080, M2=33480, Q1= 3, Q2=93
Calculate the parity bits as follows:
1. Initialize $\lambda_i = s_i, i = 0..K-1$,
and $p_j = 0, j = 0..M_1 + M_2 - 1$
2. For the $\lambda_m, m = 0..359$ accumulate $\lambda_m$ at parity bit addresses

$$(x + m \times Q_1) \bmod M_1 \qquad \text{if } x < M_1$$
$$M_1 + \left\{(x - M_1 + m \times Q_2) \bmod M_2\right\} \qquad \text{if } x \geq M_1$$

where x denotes the address of the parity bit accumulator corresponding to the first bit $\lambda_0$.
3. For the 360-th information bit $\lambda_L$, the addresses of the parity bit accumulators are given in the second row of Table 7 and Table 8. In a similar manner, the addresses of the parity bit accumulators for the following $\lambda_m$ for m = L+1, L+2, ..., 2L-1 are obtained using

$$(x + m \times Q_1) \bmod M_1 \qquad \text{if } x < M_1$$
$$M_1 + \left\{(x - M_1 + m \times Q_2) \bmod M_2\right\} \qquad \text{if } x \geq M_1$$

where x denotes the address of $\lambda_L$, the entries in the second row of the tables.
4. In a similar manner, for every group of 360 new information bits, a new row from Table 7 and Table 8 is used to find the addresses of the parity bit accumulators.
5. After the codeword bits from $\lambda_0$ to $\lambda_{K-1}$ are exhausted, sequentially perform the following operations starting with i=1

$$p_i = p_i \oplus p_{i-1} \qquad \text{for} \quad i = 1, 2, \ldots, M_1 - 1$$

6. The parity bits from $\lambda_K$ to $\lambda_{K+M_1-1}$ are obtained using the following interleaving operation (L=360):

$$\lambda_{K+L \cdot t + s} = p_{Q_1 \cdot s + t} \quad \text{for } 0 \leq s < L, \ 0 \leq t < Q_1$$

7. For every group of L=360 new codeword from $\lambda_K$ to $\lambda_{K+M_1-1}$, the addresses of the parity bit accumulators are calculated by a new row from Table 7 and Table 8 and

$$(x + m \times Q_1) \bmod M_1 \qquad \text{if } x < M_1$$
$$M_1 + \left\{(x - M_1 + m \times Q_2) \bmod M_2\right\} \qquad \text{if } x \geq M_1$$

8. After the codeword bits from $\lambda_K$ to $\lambda_{K+M_1-1}$, are exhausted, the parity bits from $\lambda_{K+M_1}$ to $\lambda_{K+M_1+M_2-1}$ are obtained using the following interleaving operation:

$$\lambda_{K+M_1+L \cdot t + s} = p_{M_1 + Q_2 \cdot s + t} \quad \text{for } 0 \leq s < L, \ 0 \leq t < Q_2$$

9. The codeword bits $\lambda_i$ for i=0..N-1 are passed to the subsequently described parallel bit interleaver.

**Table 7: LDPC code description for code rate 6/15 and codeword length 64800**

| |
|---|
| 71 276 856 6867 12964 17373 18159 26420 28460 28477 |
| 257 322 672 2533 5316 6578 9037 10231 13845 36497 |
| 233 765 904 1366 3875 13145 15409 18620 23910 30825 |
| 100 224 405 12776 13868 14787 16781 23886 29099 31419 |
| 23 496 891 2512 12589 14074 19392 20339 27658 28684 |
| 473 712 759 1283 4374 9898 12551 13814 24242 32728 |
| 511 567 815 11823 17106 17900 19338 22315 24396 26448 |
| 45 733 836 1923 3727 17468 25746 33806 35995 36657 |
| 17 487 675 2670 3922 5145 18009 23993 31073 36624 |
| 72 751 773 1937 17324 28512 30666 30934 31016 31849 |
| 257 343 594 14041 19141 24914 26864 28809 32055 34753 |
| 99 241 491 2650 9670 17433 17785 18988 22235 30742 |
| 198 299 655 6737 8304 10917 16092 19387 20755 37690 |
| 351 916 926 18151 21708 23216 30321 33578 34052 37949 |
| 54 332 373 2010 3332 5623 16301 34337 36451 37861 |
| 139 257 1068 11090 20289 29694 29732 32640 35133 36404 |
| 457 885 968 2115 4956 5422 5949 17570 26673 32387 |
| 137 570 619 5006 6099 7979 14429 16650 25443 32789 |
| 46 282 287 10258 18383 20258 27186 27494 28429 38266 |
| 445 486 1058 1868 9976 11294 20364 23695 30826 35330 |
| 134 900 931 12518 14544 17715 19623 21111 33868 34570 |
| 62 66 586 8020 20270 23831 31041 31965 32224 35189 |
| 174 290 784 6740 14673 17642 26286 27382 33447 34879 |
| 332 675 1033 1838 12004 15439 20765 31721 34225 38863 |
| 527 558 832 3867 6318 8317 10883 13466 18427 25377 |
| 431 780 1021 1112 2873 7675 13059 17793 20570 20771 |
| 339 536 1015 5725 6916 10846 14487 21156 28123 32614 |
| 456 830 1078 7511 11801 12362 12705 17401 28867 34032 |
| 222 538 989 5593 6022 8302 14008 23445 25127 29022 |
| 37 393 788 3025 7768 11367 22276 22761 28232 30394 |
| 234 257 1045 1307 2908 6337 26530 28142 34129 35997 |
| 35 46 978 9912 9978 12567 17843 24194 34887 35206 |
| 39 959 967 5027 10847 14657 18859 28075 28214 36325 |
| 275 477 823 11376 18073 28997 30521 31661 31941 32116 |
| 185 580 966 11733 12013 12760 13358 19372 32534 35504 |
| 760 891 1046 11150 20358 21638 29930 31014 33050 34840 |
| 360 389 1057 5316 5938 14186 16404 32445 34021 35722 |
| 306 344 679 5224 6674 10305 18753 25583 30585 36943 |

(continued)

| |
|---|
| 103 171 1016 8780 11741 12144 19470 20955 22495 27377 |
| 818 832 894 3883 14279 14497 22505 28129 28719 31246 |
| 215 411 760 5886 25612 28556 32213 32704 35901 36130 |
| 229 489 1067 2385 8587 20565 23431 28102 30147 32859 |
| 288 664 980 8138 8531 21676 23787 26708 28798 34490 |
| 89 552 847 6656 9889 23949 26226 27080 31236 35823 |
| 66 142 443 3339 3813 7977 14944 15464 19186 25983 |
| 605 876 931 16682 17669 25800 28220 33432 35738 37382 |
| 346 423 806 5669 7668 8789 9928 19724 24039 27893 |
| 48 460 1055 3512 7389 7549 20216 22180 28221 35437 |
| 187 636 824 1678 4508 13588 19683 21750 30311 33480 |
| 25 768 935 2856 8187 9052 21850 29941 33217 34293 |
| 349 624 716 2698 6395 6435 8974 10649 15932 17378 |
| 336 410 871 3582 9830 10885 13892 18027 19203 36659 |
| 176 849 1078 17302 19379 27964 28164 28720 32557 35495 |
| 234 890 1075 9431 9605 9700 10113 11332 12679 24268 |
| 516 638 733 8851 19871 22740 25791 30152 32659 35568 |
| 253 830 879 2086 16885 22952 23765 25389 34656 37293 |
| 94 954 998 2003 3369 6870 7321 29856 31373 34888 |
| 79 350 933 4853 6252 11932 12058 21631 24552 24876 |
| 246 647 778 4036 10391 10656 13194 32335 32360 34179 |
| 149 339 436 6971 8356 8715 11577 22376 28684 31249 |
| 36 149 220 6936 18408 19192 19288 23063 28411 35312 |
| 273 683 1042 6327 10011 18041 21704 29097 30791 31425 |
| 46 138 722 2701 10984 13002 19930 26625 28458 28965 |
| 12 1009 1040 1990 2930 5302 21215 22625 23011 29288 |
| 125 241 819 2245 3199 8415 21133 26786 27226 38838 |
| 45 476 1075 7393 15141 20414 31244 33336 35004 38391 |
| 432 578 667 1343 10466 11314 11507 23314 27720 34465 |
| 248 291 556 1971 3989 8992 18000 19998 23932 34652 |
| 68 694 837 2246 7472 7873 11078 12868 20937 35591 |
| 272 924 949 2030 4360 6203 9737 19705 19902 38039 |
| 21 314 979 2311 2632 4109 19527 21920 31413 34277 |
| 197 253 804 1249 4315 10021 14358 20559 27099 30525 |
| 9802 16164 17499 22378 22403 22704 26742 29908 |
| 9064 10904 12305 14057 16156 26000 32613 34536 |
| 5178 6319 10239 19343 25628 30577 31110 32291 |

**Table 8: LDPC code description for core rate 7/15 and codeword length 64800**

| |
|---|
| 460 792 1007 4580 11452 13130 26882 27020 32439 |
| 35 472 1056 7154 12700 13326 13414 16828 19102 |
| 45 440 772 4854 7863 26945 27684 28651 31875 |
| 744 812 892 1509 9018 12925 14140 21357 25106 |
| 271 474 7614268 6706 9609 19701 19707 24870 |
| 223 477 662 1987 9247 18376 22148 24948 27694 |
| 44 379 786 8823 12322 14666 16377 28688 29924 |
| 104 219 562 5832 19665 20615 21043 22759 32180 |
| 41 43 870 7963 13718 14136 17216 30470 33428 |
| 592 744 887 4513 6192 18116 19482 25032 34095 |
| 456 821 1078 7162 7443 8774 15567 17243 33085 |
| 151 666 977 6946 10358 11172 18129 19777 32234 |
| 236 793 870 2001 6805 9047 13877 30131 34252 |
| 297 698 772 3449 4204 11608 22950 26071 27512 |
| 202 428 474 3205 3726 6223 7708 20214 25283 |
| 139 719 915 1447 2938 11864 15932 21748 28598 |
| 135 853 902 3239 18590 20579 30578 33374 34045 |
| 9 13 971 11834 13642 17628 21669 24741 30965 |
| 344 531 730 1880 16895 17587 21901 28620 31957 |
| 7 192 380 3168 3729 5518 6827 20372 34168 |
| 28 521 681 4313 7465 14209 21501 23364 25980 |
| 269 393 898 356111066 11985 17311 26127 30309 |
| 42 82 707 4880 4890 9818 23340 25959 31695 |
| 189 262 707 6573 14082 22259 24230 24390 24664 |
| 383 568 573 5498 13449 13990 16904 22629 34203 |
| 585 596 820 2440 2488 21956 28261 28703 29591 |
| 755 763 795 5636 16433 21714 23452 31150 34545 |
| 23 343 669 1159 3507 13096 17978 24241 34321 |
| 316 384 944 4872 8491 18913 21085 23198 24798 |
| 64 314 765 3706 7136 8634 14227 17127 23437 |
| 220 693 899 8791 12417 13487 18335 22126 27428 |
| 285 794 1045 8624 8801 9547 19167 21894 32657 |
| 386 621 1045 1634 1882 3172 13686 16027 22448 |
| 95 622 693 2827 7098 11452 14112 18831 31308 |
| 446 813 928 7976 8935 13146 27117 27766 33111 |
| 89 138 241 3218 9283 20458 31484 31538 34216 |
| 277 420 704 928112576 12788 14496 15357 20585 |
| 141 643 758 4894 10264 15144 16357 22478 26461 |

(continued)

| | | | | | | | | |
|---|---|---|---|---|---|---|---|---|
| 17 | 108 | 160 | 13183 | 15424 | 17939 | 19276 | 23714 | 26655 |
| 109 | 285 | 608 | 1682 | 20223 | 21791 | 24615 | 29622 | 31983 |
| 123 | 515 | 622 | 7037 | 13946 | 15292 | 15606 | 16262 | 23742 |
| 264 | 565 | 923 | 6460 | 13622 | 13934 | 23181 | 25475 | 26134 |
| 202 | 548 | 789 | 8003 | 10993 | 12478 | 16051 | 25114 | 27579 |
| 121 | 450 | 575 | 5972 | 10062 | 18693 | 21852 | 23874 | 28031 |
| 507 | 560 | 889 | 12064 | 13316 | 19629 | 21547 | 25461 | 28732 |
| 664 | 786 | 1043 | 9137 | 9294 | 10163 | 23389 | 31436 | 34297 |
| 45 | 830 | 907 | 10730 | 16541 | 21232 | 30354 | 30605 | 31847 |
| 203 | 507 | 1060 | 6971 | 12216 | 13321 | 17861 | 22671 | 29825 |
| 369 | 881 | 952 | 3035 | 12279 | 12775 | 17682 | 17805 | 34281 |
| 683 | 709 | 1032 | 3787 | 17623 | 24138 | 26775 | 31432 | 33626 |
| 524 | 792 | 1042 | 12249 | 14765 | 18601 | 25811 | 32422 | 33163 |
| 137 | 639 | 688 | 7182 | 8169 | 10443 | 22530 | 24597 | 29039 |
| 159 | 643 | 749 | 16386 | 17401 | 24135 | 28429 | 33468 | 33469 |
| 107 | 481 | 555 | 7322 | 13234 | 19344 | 23498 | 26581 | 31378 |
| 249 | 389 | 523 | 3421 | 10150 | 17616 | 19085 | 20545 | 32069 |
| 395 | 738 | 1045 | 2415 | 3005 | 3820 | 19541 | 23543 | 31068 |
| 27 | 293 | 703 | 1717 | 3460 | 8326 | 8501 | 10290 | 32625 |
| 126 | 247 | 515 | 6031 | 9549 | 10643 | 22067 | 29490 | 34450 |
| 331 | 471 | 1007 | 3020 | 3922 | 7580 | 23358 | 28620 | 30946 |
| 222 | 542 | 1021 | 3291 | 3652 | 13130 | 16349 | 33009 | 34348 |
| 532 | 719 | 1038 | 5891 | 7528 | 23252 | 25472 | 31395 | 31774 |
| 145 | 398 | 774 | 7816 | 13887 | 14936 | 23708 | 31712 | 33160 |
| 88 | 536 | 600 | 1239 | 1887 | 12195 | 13782 | 16726 | 27998 |
| 151 | 269 | 585 | 1445 | 3178 | 3970 | 15568 | 20358 | 21051 |
| 650 | 819 | 865 | 15567 | 18546 | 25571 | 32038 | 33350 | 33620 |
| 93 | 469 | 800 | 6059 | 10405 | 12296 | 17515 | 21354 | 22231 |
| 97 | 206 | 951 | 6161 | 16376 | 27022 | 29192 | 30190 | 30665 |
| 412 | 549 | 986 | 5833 | 10583 | 10766 | 24946 | 28878 | 31937 |
| 72 | 604 | 659 | 5267 | 12227 | 21714 | 32120 | 33472 | 33974 |
| 25 | 902 | 912 | 1137 | 2975 | 9642 | 11598 | 25919 | 28278 |
| 420 | 976 | 1055 | 8473 | 11512 | 20198 | 21662 | 25443 | 30119 |
| 1 | 24 | 932 | 6426 | 11899 | 13217 | 13935 | 16548 | 29737 |
| 53 | 618 | 988 | 6280 | 7267 | 11676 | 13575 | 15532 | 25787 |
| 111 | 739 | 809 | 8133 | 12717 | 12741 | 20253 | 20608 | 27850 |
| 120 | 683 | 943 | 14496 | 15162 | 15440 | 18660 | 27543 | 32404 |
| 600 | 754 | 1055 | 7873 | 9679 | 17351 | 27268 | 33508 | |
| 344 | 756 | 1054 | 7102 | 7193 | 22903 | 24720 | 27883 | |

(continued)

| |
|---|
| 582 1003 1046 11344 23756 27497 27977 32853 |
| 28 429 509 11106 11767 12729 13100 31792 |
| 131 555 907 5113 10259 10300 20580 23029 |
| 406 915 977 12244 20259 26616 27899 32228 |
| 46 195 224 1229 4116 10263 13608 17830 |
| 19 819 953 7965 9998 13959 30580 30754 |
| 164 1003 1032 12920 15975 16582 22624 27357 |
| 8433 11894 13531 17675 25889 31384 |
| 3166 3813 8596 10368 25104 29584 |
| 2466 8241 12424 13376 24837 32711 |

The LDPC code with code rate of 8/15 is defined by way of the following algorithm:

1. The code bits are denoted by $c_0$, $c_1$,..., $c_{N-1}$, where the first K bits equal information bits, i.e., $c_k = i_k$ for $0 \leq k < K$. The parity bits $p_k = c_{k+K}$ are computed as follows.
2. Initialize $p_k = 0$ for $0 \leq k < N - K$, where N = 64800, and K = N*code rate
3. For $0 \leq k < K$, set $i = \lfloor k/360 \rfloor$, with $\lfloor x \rfloor$ being the largest integer not greater than x, and $l = k \mod 360$. Now accumulate $i_k$ to $p_{q(i,j,l)}$ for all j:

$$p_{q(i,0,l)} = p_{q(i,0,l)} + i_k, \quad p_{q(i,1,l)} = p_{q(i,1,l)} + i_k, \quad p_{q(i,2,l)} = p_{q(i,2,l)} + i_k,$$

$$p_{q(i,w(i)-1,l)} = p_{q(i,w(i)-1,l)} + i_k,$$

where w(i) is the number of elements in the i-th row in the indices list in Table 9.
4. For all $0 < k < N-K$, $p_k = (p_k + p_{k-1}) \mod 2$.
5. By the above steps, all code bits $c_0$, $c_1$, ..., $c_{N-1}$ are obtained. A parity interleaver is applied to the last N - K codebits:

$$u_i = c_i, \ 0 \leq i < K$$

$$u_{K+360t+s} = c_{K+Rs+t}, \ 0 \leq s < 360, \ 0 \leq t < R.$$

The role of the parity interleaver is to convert the staircase structure of the parity-part of the LDPC parity-check matrix into a quasi-cyclic structure similar to the information-part of the matrix. The parity interleaved code bits $u_0$, $u_1$, ..., $u_{N-1}$ are then passed to the parallel bit interleaver.

The parameters q(i,j,0) denote the j-th entry in the i-th row in the indices listed in Table 9 herebelow, and $q(i,j,l) = q(i,j,0) + R \cdot l \pmod{(N - K)}$ for $0 < l < 360$. All accumulations are realized by additions in GF(2). R equals 84 for code rate 8/15.

| | |
|---|---|
| 2768 3039 4059 5856 6245 7013 8157 9341 9802 10470 11521 12083 16610 18361 20321 24601 27420 28206 29788 | 5496 15681 21854 |
| 2739 8244 8891 9157 12624 12973 15534 16622 16919 18402 18780 19854 20220 20543 22306 25540 27478 27678 28053 | 12697 13407 22178 |
| 1727 2268 6246 7815 9010 9556 10134 10472 11389 14599 15719 16204 17342 17666 18850 22058 25579 25860 29207 | 12788 21227 22894 |
| 28 1346 3721 5565 7019 9240 12355 13109 14800 16040 16839 17369 17631 19357 19473 19891 20381 23911 29683 | 629 2854 6232 |
| 869 2450 4386 5316 6160 7107 10362 11132 11271 13149 16397 16532 17113 19894 22043 22784 27383 28615 28804 | 2289 18227 27458 |
| 508 4292 5831 8559 10044 10412 11283 14810 15888 17243 17538 19903 20528 22090 22652 27235 27384 28208 28485 | 7593 21935 23001 |
| 389 2248 5840 6043 7000 9054 11075 11760 12217 12565 13587 15403 19422 19528 21493 25142 27777 28566 28702 | 3836 7081 12282 |
| 1015 2002 5764 6777 9346 9629 11039 11153 12690 13068 13990 16841 17702 20021 24106 26300 29332 30081 30196 | 7925 18440 23135 |
| 1480 3084 3467 4401 4798 5187 7851 11368 12323 14325 14546 16360 17158 18010 21333 25612 26556 26906 27005 | 497 6342 9717 |
| 6925 8876 12392 14529 15253 15437 19226 19950 20321 23021 23651 24393 24653 26668 27205 28269 28529 29041 29292 | 11199 22046 30067 |
| 2547 3404 3538 4666 5126 5468 7695 8799 14732 15072 15881 17410 18971 19609 19717 22150 24941 27908 29018 | 12572 28045 28990 |
| 888 1581 2311 5511 7218 9107 10454 12252 13662 15714 15894 17025 18671 24304 25316 25556 28489 28977 29212 | 1240 2023 10933 |
| 1047 1494 1718 4645 5030 6811 7868 8146 10611 15767 17682 18391 22614 23021 23763 25478 26491 29088 29757 | 19566 20629 25186 |
| 59 1781 1900 3814 4121 8044 8906 9175 11156 14841 15789 16033 16755 17292 18550 19310 22505 29567 29850 | 6442 13303 28813 |
| 1952 3057 4399 9476 10171 10769 11335 11569 15002 19501 20621 22642 23452 24360 25109 25290 25828 28505 29122 | 4765 10572 16180 |
| 2895 3070 3437 4764 4905 6670 9244 11845 13352 13573 13975 14600 15871 17996 19672 20079 20579 25327 27958 | 552 19301 24286 |
| 612 1528 2004 4244 4599 4926 5843 7684 10122 10443 12267 14368 18413 19058 22985 24257 26202 26596 27899 | 6782 18480 21383 |
| 1361 2195 4146 6708 7158 7538 9138 9998 14862 15359 16076 18925 21401 21573 22503 24146 24247 27778 29312 | 11267 12288 15758 |
| 5229 6235 7134 7655 9139 13527 15408 16058 16705 18320 19909 20901 22238 22437 23654 25131 27550 28247 29903 | 771 5652 15531 |
| 697 2035 4887 5275 6909 9166 11805 15338 16381 18403 20425 20688 21547 24590 25171 26726 28848 29224 29412 | 16131 20047 25649 |
| 5379 17329 22659 23062 | 13227 23035 24450 |
| 11814 14759 22329 22936 | 4839 13467 27488 |
| 2423 2811 10296 12727 | 2852 4677 22993 |
| 8460 15260 16769 17290 | 2504 28116 29524 |
| 14191 14608 29536 30187 | 12518 17374 24267 |
| 7103 10069 20111 22850 | 1222 11859 27922 |
| 4285 15413 26448 29069 | 9660 17286 18261 |
| 548 2137 9189 10928 | 232 11296 29978 |
| 4581 7077 23382 23949 | 9750 11165 16295 |
| 3942 17248 19486 27922 | 4894 9505 23622 |
| 8668 10230 16922 26678 | 10861 11980 14110 |
| 6158 9980 13788 28198 | 2128 15883 22836 |
| 12422 16076 24206 29887 | 6274 17243 21989 |
| 8778 10649 18747 22111 | 10866 13202 22517 |
| 21029 22677 27150 28980 | 11159 16111 21608 |
| 7918 15423 27672 27803 | 3719 18787 22100 |
| 5927 18086 23525 | 1756 2020 23901 |
| 3397 15058 30224 | 20913 29473 30103 |
| 24016 25880 26268 | 2729 15091 26976 |
| 1096 4775 7912 | 4410 8217 12963 |
| 3259 17301 20802 | 5395 24564 28235 |
| 129 8396 15132 | 3859 17909 23051 |
| 17825 28119 28676 | 5733 26005 29797 |
| 2343 8382 28840 | 1935 3492 29773 |
| 3907 18374 20939 | 11903 21380 29914 |
| 1132 1290 8786 | 6091 10469 29997 |
| 1481 4710 28846 | 2895 8930 15594 |
| 2185 3705 26834 | 1827 10028 20070 |

## Table 9: LDPC Code description for code rate 8/15 and codeword length 64800

Although the present invention has been described by referring to specific embodiments illustrated in the enclosed figures, in particular by providing exemplary values for the key parameters N, M, and Q, the present invention is not restricted to any specific combination of such parameters. In fact, the present invention can be applied to any practically relevant combination of values (positive integers) for these parameters, such as those mentioned in the background section in the context of the DVB-T2 standard or defined by similar standards.

Further, the present invention is not restricted to a particular form for implementing the disclosed methods and devices, both in software or in hardware. Specifically, the invention may be implemented in form of a computer-readable medium having embodied thereon computer-executable instructions that are adapted for allowing a computer, a microprocessor, a microcontroller, and the like, to perform all steps of a method according to the embodiments of the present invention. The invention may also be implemented in form of an application-specific integrated circuit (ASIC) or in form of a field programmable gate array (FPGA).

Summarizing, the present invention relates to digital communication systems based on quasi-cyclic low-density parity-check (QC-LDPC) codes and high-order constellations. The invention provides specific permutations for interleaving bits of an LDPC codeword and specific non-uniform constellations for transmitting the interleaved codeword. The permutations and the non-uniform constellations have been jointly optimized for code rates of 6/15, 7/15, and 8/15.

**Claims**

1. A method for communicating data in a digital communication system employing a quasi-cyclic low-density parity-check code, the method comprising:

an interleaving step for applying a cyclic block permutation to a codeword of the quasi-cyclic low-density parity-check code, the codeword consisting of a sequence of N cyclic blocks, each cyclic block consisting of Q bits, N and Q being positive integers, the cyclic block permutation being configured for permuting the sequence of cyclic blocks within the codeword; and

a constellation mapping or de-mapping step for mapping bits of the permuted codeword to constellation points of a non-uniform constellation, or vice versa, the non-uniform constellation and the cyclic-block permutation being selected on the basis of a code rate of the employed quasi-cyclic low-density parity-check code.

2. A method according to claim 1, wherein the quasi-cyclic low-density parity-check code has a code rate of 6/15 and the selected non-uniform constellation is a non-uniform 4096-QAM constellation having real and complex coordinates given by non-uniform 64-PAM according to the following table:

| Address Label x (integer, MSB first) | PAM spots p(x) | Address Label x (integer, MSB first) | PAM spots p(x) | Address Label x (integer, MSB first) | PAM spots p(x) | Address Label x (integer, MSB first) | PAM spots p(x) |
|---|---|---|---|---|---|---|---|
| 0 | 1,7263 | 16 | 0,1107 | 32 | -1,7263 | 48 | -0,1107 |
| 1 | 1,4611 | 17 | 0,111 | 33 | -1,4611 | 49 | -0,111 |
| 2 | 1,1929 | 18 | 0,1099 | 34 | -1,1929 | 50 | -0,1099 |
| 3 | 1,2504 | 19 | 0,11 | 35 | -1,2504 | 51 | -0,11 |
| 4 | 0,9179 | 20 | 0,1161 | 36 | -0,9179 | 52 | -0,1161 |
| 5 | 0,9107 | 21 | 0,1166 | 37 | -0,9107 | 53 | -0,1166 |
| 6 | 0,9856 | 22 | 0,1157 | 38 | -0,9856 | 54 | -0,1157 |
| 7 | 0,972 | 23 | 0,1158 | 39 | -0,972 | 55 | -0,1158 |
| 8 | 0,5891 | 24 | 0,3626 | 40 | -0,5891 | 56 | -0,3626 |
| 9 | 0,5902 | 25 | 0,3619 | 41 | -0,5902 | 57 | -0,3619 |
| 10 | 0,5809 | 26 | 0,366 | 42 | -0,5809 | 58 | -0,366 |
| 11 | 0,5821 | 27 | 0,3659 | 43 | -0,5821 | 59 | -0,3659 |
| 12 | 0,6911 | 28 | 0,3341 | 44 | -0,6911 | 60 | -0,3341 |
| 13 | 0,6944 | 29 | 0,3333 | 45 | -0,6944 | 61 | -0,3333 |
| 14 | 0,6678 | 30 | 0,3374 | 46 | -0,6678 | 62 | -0,3374 |
| 15 | 0,6709 | 31 | 0,3368 | 47 | -0,6709 | 63 | -0,3368 |

3. A method according to claim 1 or 2, wherein the quasi-cyclic low-density parity-check code has a code rate of 6/15 and the selected cyclic-block permutation or its inverse is defined according to the following table:

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 42 | 45 | 175 | 90 | 2 | 135 | 24 |
| 1 | 46 | 46 | 36 | 91 | 127 | 136 | 126 |
| 2 | 135 | 47 | 138 | 92 | 69 | 137 | 58 |
| 3 | 82 | 48 | 100 | 93 | 56 | 138 | 96 |
| 4 | 17 | 49 | 4 | 94 | 176 | 139 | 49 |
| 5 | 50 | 50 | 11 | 95 | 54 | 140 | 170 |
| 6 | 131 | 51 | 168 | 96 | 31 | 141 | 162 |
| 7 | 65 | 52 | 40 | 97 | 38 | 142 | 71 |
| 8 | 145 | 53 | 105 | 98 | 45 | 143 | 85 |
| 9 | 164 | 54 | 103 | 99 | 132 | 144 | 6 |
| 10 | 1 | 55 | 20 | 100 | 118 | 145 | 102 |
| 11 | 141 | 56 | 152 | 101 | 98 | 146 | 114 |
| 12 | 179 | 57 | 171 | 102 | 83 | 147 | 99 |
| 13 | 130 | 58 | 155 | 103 | 13 | 148 | 62 |
| 14 | 81 | 59 | 93 | 104 | 30 | 149 | 115 |
| 15 | 52 | 60 | 66 | 105 | 149 | 150 | 109 |
| 16 | 142 | 61 | 48 | 106 | 86 | 151 | 122 |
| 17 | 108 | 62 | 124 | 107 | 57 | 152 | 148 |
| 18 | 116 | 63 | 12 | 108 | 22 | 153 | 92 |
| 19 | 174 | 64 | 113 | 109 | 143 | 154 | 106 |
| 20 | 47 | 65 | 73 | 110 | 90 | 155 | 137 |
| 21 | 44 | 66 | 139 | 111 | 34 | 156 | 125 |
| 22 | 157 | 67 | 104 | 112 | 35 | 157 | 129 |
| 23 | 64 | 68 | 107 | 113 | 88 | 158 | 153 |

(continued)

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block Group-wise Interleaver output | π(j)-th block of Group-wise Interleaver input |
|---|---|---|---|---|---|---|---|
| 24 | 27 | 69 | 37 | 114 | 79 | 159 | 15 |
| 25 | 144 | 70 | 76 | 115 | 80 | 160 | 33 |
| 26 | 120 | 71 | 72 | 116 | 75 | 161 | 89 |
| 27 | 41 | 72 | 110 | 117 | 0 | 162 | 97 |
| 28 | 91 | 73 | 154 | 118 | 146 | 163 | 8 |
| 29 | 84 | 74 | 10 | 119 | 112 | 164 | 167 |
| 30 | 29 | 75 | 43 | 120 | 67 | 165 | 177 |
| 31 | 169 | 76 | 18 | 121 | 63 | 166 | 9 |
| 32 | 156 | 77 | 78 | 122 | 77 | 167 | 172 |
| 33 | 123 | 78 | 151 | 123 | 136 | 168 | 25 |
| 34 | 53 | 79 | 16 | 124 | 51 | 169 | 26 |
| 35 | 21 | 80 | 70 | 125 | 14 | 170 | 133 |
| 36 | 121 | 81 | 7 | 126 | 60 | 171 | 101 |
| 37 | 94 | 82 | 140 | 127 | 59 | 172 | 166 |
| 38 | 147 | 83 | 87 | 128 | 39 | 173 | 32 |
| 39 | 159 | 84 | 23 | 129 | 128 | 174 | 111 |
| 40 | 117 | 85 | 68 | 130 | 74 | 175 | 61 |
| 41 | 163 | 86 | 3 | 131 | 119 | 176 | 28 |
| 42 | 178 | 87 | 19 | 132 | 150 | 177 | 160 |
| 43 | 55 | 88 | 134 | 133 | 158 | 178 | 165 |
| 44 | 173 | 89 | 161 | 134 | 5 | 179 | 95 |

4. A method according to claim 1, wherein the quasi-cyclic low-density parity-check code has a code rate of 7/15 and the selected non-uniform constellation is a non-uniform 4096-QAM constellation having real and complex coordinates given by non-uniform 64-PAM according to the following table:

| Address Label $x$ (integer, MSB first) | PAM spots $p(x)$ | Address Label $x$ (integer, MSB first) | PAM spots $p(x)$ | Address Label $x$ (integer, MSB first) | PAM spots $p(x)$ | Address Label $x$ (integer, MSB first) | PAM spots $p(x)$ |
|---|---|---|---|---|---|---|---|
| 0 | 1,6851 | 16 | 0,081 | 32 | -1,6851 | 48 | -0,081 |
| 1 | 1,4381 | 17 | 0,0808 | 33 | -1,4381 | 49 | -0,0808 |
| 2 | 1,1766 | 18 | 0,081 | 34 | -1,1766 | 50 | -0,081 |
| 3 | 1,2355 | 19 | 0,0807 | 35 | -1,2355 | 51 | -0,0807 |
| 4 | 0,9162 | 20 | 0,1456 | 36 | -0,9162 | 52 | -0,1456 |
| 5 | 0,9089 | 21 | 0,1456 | 37 | -0,9089 | 53 | -0,1456 |
| 6 | 1,0012 | 22 | 0,1456 | 38 | -1,0012 | 54 | -0,1456 |
| 7 | 0,9771 | 23 | 0,1457 | 39 | -0,9771 | 55 | -0,1457 |
| 8 | 0,5684 | 24 | 0,4036 | 40 | -0,5684 | 56 | -0,4036 |
| 9 | 0,5681 | 25 | 0,4036 | 41 | -0,5681 | 57 | -0,4036 |
| 10 | 0,5704 | 26 | 0,4043 | 42 | -0,5704 | 58 | -0,4043 |
| 11 | 0,57 | 27 | 0,4042 | 43 | -0,57 | 59 | -0,4042 |
| 12 | 0,7385 | 28 | 0,3059 | 44 | -0,7385 | 60 | -0,3059 |
| 13 | 0,7425 | 29 | 0,306 | 45 | -0,7425 | 61 | -0,306 |
| 14 | 0,7155 | 30 | 0,3056 | 46 | -0,7155 | 62 | -0,3056 |
| 15 | 0,7186 | 31 | 0,3057 | 47 | -0,7186 | 63 | -0,3057 |

5. A method according to claim 1 or 4, wherein the quasi-cyclic low-density parity-check code has a code rate of 7/15 and the selected cyclic-block permutation or its inverse is defined according to the following table:

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 0 | 59 | 45 | 101 | 90 | 138 | 135 | 24 |
| 1 | 122 | 46 | 4 | 91 | 51 | 136 | 117 |
| 2 | 161 | 47 | 5 | 92 | 89 | 137 | 154 |
| 3 | 93 | 48 | 87 | 93 | 88 | 138 | 157 |
| 4 | 37 | 49 | 106 | 94 | 167 | 139 | 164 |
| 5 | 112 | 50 | 79 | 95 | 80 | 140 | 143 |
| 6 | 111 | 51 | 104 | 96 | 142 | 141 | 12 |
| 7 | 62 | 52 | 168 | 97 | 108 | 142 | 56 |
| 8 | 42 | 53 | 163 | 98 | 69 | 143 | 152 |
| 9 | 102 | 54 | 170 | 99 | 7 | 144 | 20 |
| 10 | 119 | 55 | 57 | 100 | 103 | 145 | 85 |
| 11 | 72 | 56 | 83 | 101 | 115 | 146 | 84 |
| 12 | 60 | 57 | 44 | 102 | 99 | 147 | 77 |
| 13 | 144 | 58 | 54 | 103 | 135 | 148 | 158 |
| 14 | 34 | 59 | 110 | 104 | 36 | 149 | 107 |
| 15 | 120 | 60 | 30 | 105 | 11 | 150 | 32 |
| 16 | 46 | 61 | 50 | 106 | 166 | 151 | 153 |
| 17 | 31 | 62 | 82 | 107 | 169 | 152 | 147 |
| 18 | 129 | 63 | 10 | 108 | 8 | 153 | 132 |
| 19 | 172 | 64 | 148 | 109 | 165 | 154 | 124 |
| 20 | 149 | 65 | 98 | 110 | 68 | 155 | 52 |
| 21 | 94 | 66 | 41 | 111 | 173 | 156 | 121 |
| 22 | 65 | 67 | 22 | 112 | 140 | 157 | 58 |
| 23 | 9 | 68 | 96 | 113 | 95 | 158 | 118 |
| 24 | 0 | 69 | 49 | 114 | 179 | 159 | 137 |

(continued)

| j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input |
|---|---|---|---|---|---|---|---|
| 25 | 76 | 70 | 90 | 115 | 2 | 160 | 114 |
| 26 | 13 | 71 | 100 | 116 | 125 | 161 | 97 |
| 27 | 61 | 72 | 29 | 117 | 105 | 162 | 19 |
| 28 | 3 | 73 | 39 | 118 | 1 | 163 | 155 |
| 29 | 70 | 74 | 175 | 119 | 116 | 164 | 67 |
| 30 | 40 | 75 | 38 | 120 | 150 | 165 | 25 |
| 31 | 78 | 76 | 109 | 121 | 174 | 166 | 17 |
| 32 | 127 | 77 | 91 | 122 | 15 | 167 | 126 |
| 33 | 35 | 78 | 74 | 123 | 75 | 168 | 23 |

| | | | | | | | |
|---|---|---|---|---|---|---|---|
| 34 | 145 | 79 | 159 | 124 | 64 | 169 | 43 |
| 35 | 28 | 80 | 139 | 125 | 176 | 170 | 27 |
| 36 | 48 | 81 | 177 | 126 | 81 | 171 | 21 |
| 37 | 162 | 82 | 71 | 127 | 55 | 172 | 136 |
| 38 | 92 | 83 | 47 | 128 | 130 | 173 | 131 |
| 39 | 73 | 84 | 146 | 129 | 151 | 174 | 26 |
| 40 | 6 | 85 | 63 | 130 | 156 | 175 | 14 |
| 41 | 134 | 86 | 86 | 131 | 53 | 176 | 18 |
| 42 | 66 | 87 | 45 | 132 | 171 | 177 | 128 |
| 43 | 160 | 88 | 123 | 133 | 16 | 178 | 141 |
| 44 | 133 | 89 | 33 | 134 | 113 | 179 | 178 |

**6.** A method according to claim 1, wherein the quasi-cyclic low-density parity-check code has a code rate of 8/15 and the selected non-uniform constellation is a non-uniform 4096-QAM constellation having real and complex coordinates given by non-uniform 64-PAM according to the following table:

| Address Label $x$ (integer, MSB first) | PAM spots $p(x)$ | Address Label $x$ (integer, MSB first) | PAM spots $p(x)$ | Address Label $x$ (integer, MSB first) | PAM spots $p(x)$ | Address Label $x$ (integer, MSB first) | PAM spots $p(x)$ |
|---|---|---|---|---|---|---|---|
| 0 | 1,6651 | 16 | 0,0695 | 32 | -1,6651 | 48 | -0,0695 |
| 1 | 1,4272 | 17 | 0,0694 | 33 | -1,4272 | 49 | -0,0694 |
| 2 | 1,1713 | 18 | 0,0696 | 34 | -1,1713 | 50 | -0,0696 |
| 3 | 1,2329 | 19 | 0,0697 | 35 | -1,2329 | 51 | -0,0697 |
| 4 | 0,9125 | 20 | 0,1629 | 36 | -0,9125 | 52 | -0,1629 |
| 5 | 0,9069 | 21 | 0,1629 | 37 | -0,9069 | 53 | -0,1629 |
| 6 | 1,0081 | 22 | 0,1629 | 38 | -1,0081 | 54 | -0,1629 |
| 7 | 0,9831 | 23 | 0,163 | 39 | -0,9831 | 55 | -0,163 |
| 8 | 0,5697 | 24 | 0,4194 | 40 | -0,5697 | 56 | -0,4194 |
| 9 | 0,5694 | 25 | 0,4196 | 41 | -0,5694 | 57 | -0,4196 |
| 10 | 0,5739 | 26 | 0,4196 | 42 | -0,5739 | 58 | -0,4196 |
| 11 | 0,5733 | 27 | 0,4195 | 43 | -0,5733 | 59 | -0,4195 |
| 12 | 0,7459 | 28 | 0,3034 | 44 | -0,7459 | 60 | -0,3034 |
| 13 | 0,7496 | 29 | 0,3035 | 45 | -0,7496 | 61 | -0,3035 |
| 14 | 0,7192 | 30 | 0,3032 | 46 | -0,7192 | 62 | -0,3032 |
| 15 | 0,7216 | 31 | 0,3032 | 47 | -0,7216 | 63 | -0,3032 |

**7.** A method according to claim 1 or 6, wherein the quasi-cyclic low-density parity-check code has a code rate of 8/15 and the selected cyclic-block permutation or its inverse is defined according to the following table:

| π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output |
|---|---|---|---|---|---|---|---|
| 166 | 135 | 56 | 90 | 161 | 45 | 82 | 0 |
| 16 | 136 | 144 | 91 | 69 | 46 | 75 | 1 |
| 131 | 137 | 74 | 92 | 8 | 47 | 51 | 2 |
| 105 | 138 | 89 | 93 | 156 | 48 | 24 | 3 |
| 159 | 139 | 14 | 94 | 52 | 49 | 96 | 4 |
| 0 | 140 | 107 | 95 | 45 | 50 | 80 | 5 |
| 136 | 141 | 37 | 96 | 27 | 51 | 152 | 6 |
| 115 | 142 | 113 | 97 | 154 | 52 | 118 | 7 |
| 122 | 143 | 44 | 98 | 129 | 53 | 147 | 8 |
| 117 | 144 | 19 | 99 | 4 | 54 | 169 | 9 |
| 62 | 145 | 17 | 100 | 38 | 55 | 64 | 10 |
| 3 | 146 | 35 | 101 | 177 | 56 | 106 | 11 |
| 178 | 147 | 88 | 102 | 127 | 57 | 60 | 12 |
| 57 | 148 | 101 | 103 | 49 | 58 | 22 | 13 |
| 59 | 149 | 28 | 104 | 167 | 59 | 65 | 14 |
| 179 | 150 | 63 | 105 | 120 | 60 | 46 | 15 |
| 7 | 151 | 108 | 106 | 100 | 61 | 79 | 16 |
| 20 | 152 | 109 | 107 | 12 | 62 | 140 | 17 |
| 34 | 153 | 10 | 108 | 173 | 63 | 133 | 18 |
| 32 | 154 | 175 | 109 | 84 | 64 | 135 | 19 |
| 150 | 155 | 160 | 110 | 112 | 65 | 18 | 20 |
| 174 | 156 | 119 | 111 | 121 | 66 | 171 | 21 |
| 172 | 157 | 94 | 112 | 151 | 67 | 15 | 22 |
| 165 | 158 | 39 | 113 | 23 | 68 | 87 | 23 |
| 68 | 159 | 99 | 114 | 92 | 69 | 90 | 24 |

(continued)

| π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output | π(j)-th block of Group-wise Interleaver input | j-th block of Group-wise Interleaver output |
|---|---|---|---|---|---|---|---|
| 85 | 160 | 40 | 115 | 146 | 70 | 5 | 25 |
| 55 | 161 | 134 | 116 | 67 | 71 | 170 | 26 |
| 114 | 162 | 21 | 117 | 43 | 72 | 42 | 27 |
| 176 | 163 | 83 | 118 | 158 | 73 | 9 | 28 |
| 71 | 164 | 58 | 119 | 1 | 74 | 86 | 29 |
| 66 | 165 | 13 | 120 | 103 | 75 | 132 | 30 |
| 128 | 166 | 53 | 121 | 141 | 76 | 162 | 31 |
| 116 | 167 | 26 | 122 | 48 | 77 | 142 | 32 |
| 163 | 168 | 126 | 123 | 25 | 78 | 93 | 33 |
| 145 | 169 | 6 | 124 | 50 | 79 | 104 | 34 |
| 153 | 170 | 47 | 125 | 29 | 80 | 138 | 35 |
| 139 | 171 | 76 | 126 | 77 | 81 | 102 | 36 |
| 97 | 172 | 41 | 127 | 124 | 82 | 168 | 37 |
| 30 | 173 | 11 | 128 | 110 | 83 | 54 | 38 |
| 157 | 174 | 98 | 129 | 70 | 84 | 78 | 39 |
| 149 | 175 | 61 | 130 | 33 | 85 | 111 | 40 |
| 155 | 176 | 73 | 131 | 125 | 86 | 164 | 41 |
| 72 | 177 | 148 | 132 | 2 | 87 | 95 | 42 |
| 81 | 178 | 36 | 133 | 91 | 88 | 31 | 43 |
| 123 | 179 | 143 | 134 | 130 | 89 | 137 | 44 |

8. A method according to any of the preceding claims, wherein N=180 and Q=360.

9. A method according to any of the preceding claims, further comprising the step of selecting the employed quasi-cyclic low-density parity-check code from a plurality of predefined quasi-cyclic low-density parity-check codes, each of the predefined quasi-cyclic low-density parity-check codes having a distinct code rate.

10. A transmitter of a digital communication system, the transmitter being adapted for transmitting data by performing all steps of a method according to any of claims 1 to 9.

11. A receiver of a digital communication system, the receiver being adapted for receiving data by performing all steps of a method according to any of claims 1 to 9.

# Fig. 1

| Input Processing | BICM Encoder | OFDM Modulator | Upconverter | RF Amplifier |
|---|---|---|---|---|

110   120   130   140   150   160

# Fig. 2

# Fig. 3

Information part — Parity part

# Fig. 4

| QB | Check-node indices for the first bit in each cyclic block QB | | | | |
|----|-----|-----|-----|-----|-----|
| **1** | **13** | **24** | **27** | **31** | **47** |
| 2 | 4 | 7 | 8 | 22 | 43 |
| 3 | 2 | 15 | 20 | 33 | 35 |
| 4 | 3 | 26 | 29 | | |
| 5 | 12 | 20 | 22 | | |
| 6 | 11 | 22 | 30 | | |
| 7 | 15 | 24 | 38 | | |
| 8 | 13 | 28 | 47 | | |
| 9 | 31 | 42 | 44 | | |
| 10 | 5 | 21 | 39 | | |
| 11 | 16 | 28 | 30 | | |
| 12 | 6 | 19 | 23 | | |

# Fig. 5

Information part

# Fig. 6

QB 1   QB 2   QB 3   QB 4   QB 5   QB 6   QB 7   QB 8   QB 9   QB 10   QB 11   QB 12

Information part

Parity part

Fig. 7

QB 1  QB 2  QB 3  QB 4  QB 5  QB 6  QB 7  QB 8  QB 9  QB 10  QB 11  QB 12

Information part                                                    Parity part

# Fig. 8A

## 4-QAM

2-PAM

# Fig. 8B

## 16-QAM

4-PAM

# Fig. 8C

## 64-QAM

8-PAM

# Fig. 9A

### 4-QAM

$b_{1,Re}$ ○——→ | 2-PAM | →○ Re

$b_{1,Im}$ ○——→ | 2-PAM | →○ Im

# Fig. 9B

### 16-QAM

$b_{1,Re}$ ○——→
$b_{2,Re}$ ○——→ | 4-PAM | →○ Re

$b_{1,Im}$ ○——→
$b_{2,Im}$ ○——→ | 4-PAM | →○ Im

# Fig. 9C

### 64-QAM

$b_{1,Re}$ ○——→
$b_{2,Re}$ ○——→ | 8-PAM | →○ Re
$b_{3,Re}$ ○——→

$b_{1,Im}$ ○——→
$b_{2,Im}$ ○——→ | 8-PAM | →○ Im
$b_{3,Im}$ ○——→

# Fig. 10

**Encoded bits** $b_3$, $b_2$, $b_1$

| 100 | 101 | 111 | 110 | 010 | 011 | 001 | 000 |

**Subsets for** $b_1$=1 (black), $b_1$=0 (white)

$_{10}0$   $_{10}1$   $_{11}1$   $_{11}0$   $_{01}0$   $_{01}1$   $_{00}1$   $_{00}0$

**Subsets for** $b_2$=1 (black), $b_2$=0 (white)

$_1 0_0$   $_1 0_1$   $_1 1_1$   $_1 1_0$   $_0 1_0$   $_0 1_1$   $_0 0_1$   $_0 0_0$

**Subsets for** $b_3$=1 (black), $b_3$=0 (white)

$1_{00}$   $1_{01}$   $1_{11}$   $1_{10}$   $0_{10}$   $0_{11}$   $0_{01}$   $0_{00}$

## Fig. 11

# Fig. 12A

| | | | | | | | |
|---|---|---|---|---|---|---|---|
| QB1 | $b_{1,Re}$ | $b_{1,Im}$ | | | | | |
| QB2 | $b_{2,Re}$ | $b_{2,Im}$ | | | | | |
| QB3 | $b_{3,Re}$ | $b_{3,Im}$ | | | | | |
| QB4 | $b_{4,Re}$ | $b_{4,Im}$ | | | | | |
| QB5 | $b_{5,Re}$ | $b_{5,Im}$ | | | | | |
| QB6 | $b_{6,Re}$ | $b_{6,Im}$ | | | | | |
| QB7 | | | | | | | |
| QB8 | | | | | | | |
| QB9 | | | | | | | |
| QB10 | | | | | | | |
| QB11 | | | | | | | |
| QB12 | | | | | | | |
| QB13 | | | | | | | |
| QB14 | | | | | | | |
| QB15 | | | | | | | |
| QB16 | | | | | | | |
| QB17 | | | | | | | |
| QB18 | | | | | | | |
| QB19 | | | | | | | |
| QB20 | | | | | | | |
| QB21 | | | | | | | |
| QB22 | | | | | | | |
| QB23 | | | | | | | |
| QB24 | | | | | | | |

Section 1 (QB1–QB6)
Section 2 (QB7–QB12)
Section 3 (QB13–QB18)
Section 4 (QB19–QB24)

# Fig. 12B

122

124-1

Bit interleaver with 6 QBs per section

$b_{1,Re}$
$b_{2,Re}$
⋮
$b_{6,Re}$

64 PAM → Re

$b_{1,Im}$
$b_{2,Im}$
⋮
$b_{6,Im}$

64 PAM → Im

124-2

$s_1$

# Fig. 12C

write →

| | | | |
|---|---|---|---|
| QB1 | $b_{1,Re}$ | $b_{1,Im}$ | |
| QB2 | $b_{2,Re}$ | $b_{2,Im}$ | |
| QB3 | $b_{3,Re}$ | $b_{3,Im}$ | |
| QB4 | $b_{4,Re}$ | $b_{4,Im}$ | |
| QB5 | $b_{5,Re}$ | $b_{5,Im}$ | |
| QB6 | $b_{6,Re}$ | $b_{6,Im}$ | |

read ↓

$Re\{s_1\}$    $Im\{s_1\}$

# Fig. 13A

| | | | | | | |
|---|---|---|---|---|---|---|
| QB1 | $b_1$ | | | | | |
| QB2 | $b_2$ | | | | | |
| QB3 | $b_3$ | | | | | |
| QB4 | $b_4$ | | | | | |
| QB5 | $b_5$ | | | | | |
| QB6 | $b_6$ | | | | | |
| QB7 | $b_7$ | | | | | |
| QB8 | $b_8$ | | | | | |
| QB9 | $b_9$ | | | | | |
| QB10 | $b_{10}$ | | | | | |
| QB11 | $b_{11}$ | | | | | |
| QB12 | $b_{12}$ | | | | | |
| QB13 | | | | | | |
| QB14 | | | | | | |
| QB15 | | | | | | |
| QB16 | | | | | | |
| QB17 | | | | | | |
| QB18 | | | | | | |
| QB19 | | | | | | |
| QB20 | | | | | | |
| QB21 | | | | | | |
| QB22 | | | | | | |
| QB23 | | | | | | |
| QB24 | | | | | | |

Section 1 (QB1–QB12)

Section 2 (QB13–QB24)

# Fig. 13B

122

Bit interleaver with 12 QBs per section

$b_1$
$b_2$
⋮
$b_{12}$

124

4096 QAM

$s_1$

# Fig. 13C

write

| | | |
|---|---|---|
| QB1 | $b_1$ | |
| QB2 | $b_2$ | |
| QB3 | $b_3$ | |
| QB4 | $b_4$ | |
| QB5 | $b_5$ | |
| QB6 | $b_6$ | |
| QB7 | $b_7$ | |
| QB8 | $b_8$ | |
| QB9 | $b_9$ | |
| QB10 | $b_{10}$ | |
| QB11 | $b_{11}$ | |
| QB12 | $b_{12}$ | |

read

$s_1$

# Fig. 14

Europäisches
Patentamt

European
Patent Office

Office européen
des brevets

**EUROPEAN SEARCH REPORT**

Application Number

EP 14 16 9535

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DVB ORGANIZATION: "tm4701r4.TM-NGH1181r41_en_303105v010101_1 30603_worm_woc_wbc.docx", DVB, DIGITAL VIDEO BROADCASTING, C/O EBU - 17A ANCIENNE ROUTE - CH-1218 GRAND SACONNEX, GENEVA - SWITZERLAND, 3 June 2013 (2013-06-03), XP017840591, * Section 4.2 Bit-Interleaved Coding and Modulation on pages 34 and 35 * * figure 7 * * figures 98-100 * * Section 15. Bit Interleaver from pages 252 to 255 * * tables 4,6,26 * | 1-11 | INV. H04L27/34 H03M13/11 H03M13/25 H04L1/00 |
| X | EP 2 690 790 A1 (PANASONIC CORP [JP]) 29 January 2014 (2014-01-29) * paragraphs [0010], [0011] * * paragraphs [0015], [0016] * * paragraphs [0025], [0026] * | 1,8-11 | |
| A | DVB ORGANIZATION: "TM-T0012__Optimization-of-High-order-Non-uniform-QAM-Constellationspdf.pdf", DVB, DIGITAL VIDEO BROADCASTING, C/O EBU - 17A ANCIENNE ROUTE - CH-1218 GRAND SACONNEX, GENEVA - SWITZERLAND, 15 April 2014 (2014-04-15), XP017845158, * pages 4,8,11 * | 1,10,11 | TECHNICAL FIELDS SEARCHED (IPC) H04L H03M |

The present search report has been drawn up for all claims

| Place of search | Date of completion of the search | Examiner |
|---|---|---|
| Berlin | 13 October 2014 | Chave, Julien |

**ANNEX TO THE EUROPEAN SEARCH REPORT
ON EUROPEAN PATENT APPLICATION NO.**                    EP 14 16 9535

This annex lists the patent family members relating to the patent documents cited in  the above-mentioned European search report.
The members are as contained in the European Patent Office EDP file on
The European Patent Office is in no way liable for these particulars which are merely given for the purpose of information.

13-10-2014

| Patent document cited in search report | Publication date | Patent family member(s) | Publication date |
|---|---|---|---|
| EP 2690790    A1 | 29-01-2014 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 11006087 A